# FASCICULE DE BREVET EUROPEEN

(11) **EP 4 473 658 B1**
(45) Date de publication et mention de la délivrance du brevet: **09.04.2025**
(21) Numéro de dépôt: 23701752.0
(22) Date de dépôt: 25.01.2023
(51) Int. Cl.: H03F 3/30, H03F 3/21, H03F 3/183, H03F 3/45, H03F 1/02

(54) **AMPLIFICATEUR AUDIO HAUTE PERFORMANCE**
HOCHLEISTUNGS-AUDIOVERSTÄRKER
HIGH-PERFORMANCE AUDIO AMPLIFIER

(30) Priorité: 31.01.2022 FR 2200839
(43) Date de publication de la demande: 11.12.2024
(73) Titulaire: FOCAL JMLab, 42350 La Talaudière (FR)
(72) Inventeur: JURY, Christian, 42290 Sorbiers (FR); UHRING-CADART, Ludovic, 42290 Sorbiers (FR); MARANDON, Michel, 42580 L'Étrat (FR)
(74) Mandataire: Cabinet Laurent & Charras
(86) Numéro de dépôt international: PCT/EP2023/051797
(87) Numéro de publication internationale: WO 2023/144200

(56) Documents cités:
- US-A- 3 974 455
- PAULINAACUNA: "Amplifier - Wikipedia", 23 February 2015 (2015-02-23), XP055730600, Retrieved from the Internet <URL:https://en.wikipedia.org/w/index.php?title=Amplifier&oldid=648441166> [retrieved on 20200915]

## Description

### DOMAINE TECHNIQUE

L'invention se rapporte au domaine des amplificateurs. L'invention concerne en particulier un amplificateur audio haute-puissance destiné à commander au moins un haut-parleur.

Les amplificateurs haute-puissance trouvent notamment des applications pour sonoriser des studios d'enregistrement ou des salles de concert. Ils sont notamment utilisés pour alimenter des haut-parleurs de type électrodynamique

L'invention permet avantageusement d'obtenir un amplificateur audio haute-puissance avec un meilleur rendement que les amplificateurs de l'art antérieur, tout en garantissant une distorsion faible.

### TECHNIQUES ANTÉRIEURES

De manière classique, un amplificateur haute-puissance comporte au moins un composant actif tel qu'un transistor ou un tube permettant d'amplifier la puissance d'un signal reçu en entrée, tout en conservant la forme du signal d'entrée.

Le circuit d'un amplificateur haute puissance comprend généralement un étage de pré-amplification suivi d'un étage d'amplification de puissance. Plus précisément, la sortie de l'étage d'amplification de puissance est contre-réactionnée sur l'étage de pré-amplification de sorte que l'étage de pré-amplification détecte, au cours du temps, la différence entre le signal de sortie et le signal d'entrée, par exemple au moyen de paires différentielles. Cette différence détectée au niveau de l'étage de pré-amplification est alors amplifiée dans l'étage d'amplification de puissance pour former le signal de sortie, classiquement transmis à au moins un haut-parleur.

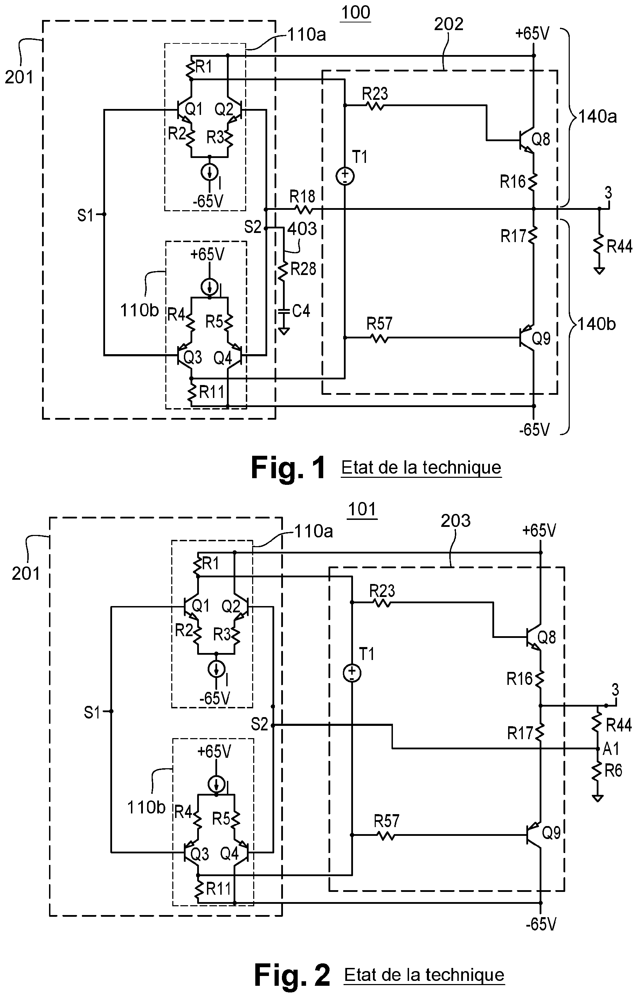

Ainsi, à titre d'exemple, la figure 1 illustre un amplificateur haute-puissance **100** dont le signal d'entrée est appliqué au point **S1.** La sortie de l'amplificateur haute-puissance **100** alimente un haut-parleur, représenté par une résistance **R44,** connecté entre un point **3** et la masse.

Le schéma de l'amplificateur haute-puissance **100** est symétrique, il comporte une partie supérieure **140a,** qui amplifie l'alternance positive du signal d'entrée **S1** et une partie inférieure **140b,** qui amplifie l'alternance négative du signal d'entrée **S1.**

Dans l'exemple de la figure 1, l'amplificateur haute-puissance **100** est alimenté par un seul niveau de tension en +/- 65 V.

L'étage de pré-amplification **201** comporte deux paires différentielles **110a, 110b** comprenant chacune deux transistors **Q1, Q2** et **Q3, Q4** montés en miroir l'un de l'autre. Ainsi, l'émetteur des transistors **Q1, Q2** est relié au bus d'alimentation en - 65V par l'intermédiaire d'une résistance **R2, R3** et d'une première source de courant constant **I,** tandis que l'émetteur des transistors **Q3, Q4** est relié au bus d'alimentation en + 65V par l'intermédiaire d'une résistance **R4, R5** et d'une seconde source de courant de même valeur **I.**

Le collecteur des transistors **Q2, Q4** est respectivement relié au bus d'alimentation en +65V et en -65V, tandis que le collecteur des transistors **Q1, Q3** est respectivement relié au bus d'alimentation en +65V et en -65V par l'intermédiaire d'une résistance **R1, R11.** En l'absence de contre-réaction, le gain de l'étage de pré-amplification **201** dépend du rapport des résistances **R1/R2** et **R11/R4.**

Les bases des transistors **Q1** et **Q3** et les bases des transistors **Q2** et **Q4** sont reliées entre-elles. Les bases des transistors **Q1** et **Q3** sont également alimentées par le signal d'entrée **S1,** Les bases des transistors **Q2** et **Q4** sont reliées au haut-parleur **R44** par l'intermédiaire d'une résistance **R18,** de sorte à former la contre-réaction appliquée sur l'étage de pré-amplification. Les collecteurs des transistors **Q1** et **Q3** assurent le couplage de l'étage de pré-amplification **201** avec l'étage d'amplification de puissance **202.**

L'étage d'amplification de puissance **202** comporte deux transistors **Q8, Q9** reliés par leur base respective à l'étage de pré-amplification **201** par l'intermédiaire d'une résistance **R23, R57.** Une source de tension **T1** est également disposée entre les résistances **R23** et **R57** de sorte à polariser les transistors **Q8, Q9** en classe AB. Cette source de tension **T1** permet de fournir une tension égale à la somme des tensions nécessaires pour rendre les transistors **Q8** et **Q9** passants.

Les transistors **Q8, Q9** sont également reliés respectivement aux bus d'alimentation en +65 V et - 65V par leur collecteur. L'émetteur des transistors **Q8, Q9** est relié au haut-parleur **R44** par l'intermédiaire de résistances **R16, R17.** Ces résistances **R16** et **R17** sont ajoutées afin de contrôler le courant de repos, c'est-à-dire la valeur du courant conduit par l'amplificateur lorsqu'il ne reçoit aucun signal d'entrée. Sans ces résistances **R16, R17,** le courant de repos serait dépendant des caractéristiques des transistors **Q8** et **Q9** et de la température, ce qui est rédhibitoire.

En outre, le circuit de la figure 1 présente une particularité au niveau des bases des transistors **Q2** et **Q4.** En effet, ces dernières sont reliées à une ligne de protection **403** comportant une résistance **R28** montée en série avec un condensateur **C4** connecté à la masse. Ce montage est un diviseur de tension tel que la tension au point **S2** est égale à **R28**/(**R18** + **R28**) multiplié par la tension du signal de sortie **3** en alternatif. En pratique, le condensateur **C4** se comporte comme un court-circuit lorsque la tension parcourant le circuit est alternative. En revanche, lorsque la tension parcourant le circuit est continue, le condensateur **C4** se comporte comme un circuit ouvert. Dans ce cas, le signal de sortie **3** de l'amplificateur haute-puissance **100** est directement relié au point **S2.** Le gain en tension de l'amplificateur haute-puissance **100** est alors égal à 1, ce qui permet de limiter une éventuelle composante continue indésirable sur la tension appliquée aux bornes du haut-parleur **R44.**

Dans ce type d'amplificateur, la tension mesurée par rapport à la masse au point **S1** et la tension mesurée par rapport à la masse au point **S2** sont égales. Autrement formulé, le gain de l'amplificateur haute-puissance **100** est égal au rapport des valeurs des résistances (**R18+R28**)/**R28.**

La figure 1 illustre donc un amplificateur haute-puissance en tension. Il existe également une autre catégorie, les amplificateurs haute-puissance en courant, tel qu'illustré sur la figure 2.

Cette catégorie d'amplificateurs haute-puissance en courant **101** présente la même topologie que pour les amplificateurs haut-puissance en tension **100,** à savoir un étage de pré-amplification **201** couplé à un étage d'amplification **203.**

A la différence de l'amplificateur haute-tension **100** de la figure 1, une résistance de mesure de courant **R6** est insérée entre le haut-parleur **R44** et la masse. En outre, l'amplificateur en courant **101** ne présente pas de ligne de protection **403.** Les bases des transistors **Q2** et **Q4** sont reliées à un point d'interconnexion **P1** situé entre la résistance **R6** et le haut-parleur **R44.**

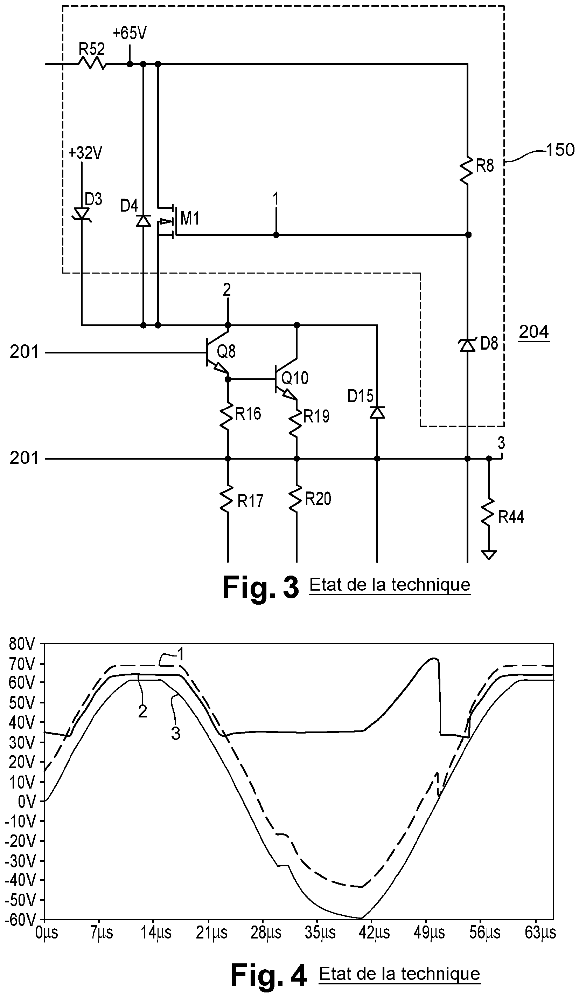

Dans cette configuration, le haut-parleur **R44** est donc traversé par une image du courant appliqué au point **S2** sur la figure 3. Il s'ensuit que la transconductance, c'est-à-dire le rapport entre le courant de sortie traversant le haut-parleur **R44** et la tension d'entrée appliquée au point **S1,** de l'amplificateur **101** est égale à 1/**R6** A/V. Pour un haut-parleur d'impédance **Z,** le gain en tension vaut **Z/R6.**

Les montages d'amplification en tension ou en courant sont donc similaires, notamment au niveau de l'étage de pré-amplification et de l'étage d'amplification de puissance. Ils ne diffèrent qu'au niveau de la connexion du haut-parleur et de la contre-réaction. Dans la suite de l'état de la technique, les autres classes d'amplificateurs seront décrits en référence à des amplificateurs de tension, bien que l'invention ne se limite pas à ce type d'amplificateur.

Un système de classes peut être utilisé pour caractériser les différentes topologies d'amplificateurs haute-puissance. Le système de classe assigne une lettre en fonction de la relation entre la forme du signal d'entrée et celui de sortie, ainsi qu'en fonction de la durée pendant laquelle les composants actifs sont utilisés lors de l'amplification du signal d'entrée.

Parmi les classes d'amplificateurs existantes, les amplificateurs de classe A présentent une topologie telle que les composants actifs conduisent, en l'absence de signal d'entrée, un courant élevé d'environ 50% du courant de sortie maximal. C'est ce que l'on appelle le courant de repos. En modulation, ce dernier se superpose au courant de sortie. Ce type d'amplificateur permet de fournir un son d'une excellente qualité, mais il présente le désavantage d'engendrer une dissipation thermique importante. Ainsi, le rendement énergétique, défini par le rapport entre la puissance de sortie efficace et la puissance absorbée, de cette classe d'amplificateurs est d'environ 10%.

Les amplificateurs de classe B présentent une topologie telle que les composants actifs conduisent sur 50% de la période du signal d'entrée lorsqu'un signal d'entrée sinusoïdal est appliqué en entrée. Pour cette classe d'amplificateurs, le courant de repos est nul. Le rendement de ce type d'amplificateur est supérieur aux amplificateurs de classe A, mais les caractéristiques de distorsion du signal de sortie sont nettement dégradées en comparaison des amplificateurs de classe A. Les amplificateurs de classe B produisent ainsi un son de moins bonne qualité. Il est désormais assez rare que des fabricants utilisent cette classe d'amplificateur.

Les amplificateurs de classe AB présentent une topologie telle que les composants actifs conduisent sur 100% de la période du signal d'entrée mais avec un courant de repos faible d'environ 1% du courant de sortie maximal. Ce type d'amplificateur présente une efficacité énergétique supérieure aux amplificateurs de classe A, typiquement comprise entre 30 et 50%, mais une qualité sonore moindre. Les amplificateurs de classe AB sont donc un bon compromis entre performance et rendement énergétique.

Pour les amplificateurs de classe D, une technologie ou les composants actifs sont actionnés comme des commutateurs est utilisée. Le signal est alors converti en modulation de largeur d'impulsion. Ce système permet d'augmenter l'efficacité énergétique à environ 70%. En revanche, le signal de sortie contient plus de bruit et de distorsions et il est difficile de restituer les hautes fréquences avec cette classe d'amplificateurs.

Les amplificateurs de classe G possèdent plusieurs bus d'alimentation et peuvent commuter de l'un à l'autre en fonction de la puissance demandée en sortie. Ceci permet d'augmenter le rendement énergétique en diminuant la puissance dissipée dans les composants actifs.

Les amplificateurs de classe H utilisent un bus d'alimentation dont la tension d'alimentation « suit », ou est modulée par le signal d'entrée. En général, ils possèdent deux bus d'alimentation, comme ceux de la classe G, mais seule la tension d'alimentation la plus élevée est modulée. L'alimentation modulée est généralement réalisée grâce à un amplificateur de classe D.

L'objet de l'invention porte en particulier sur ces deux dernières catégories d'amplificateurs.

La figure 3 illustre la partie supérieure d'un étage d'amplification de puissance **204.** Ce dernier est connecté à un circuit d'alimentation **150.** Bien entendu, cet étage d'amplification de puissance comprend également une partie inférieure non représentée, en miroir de la partie supérieure avec un circuit d'alimentation équivalent. De même, le circuit comprend également un étage de pré-amplification, par exemple connecté à une alimentation indépendante ou encore à un bus d'alimentation fort, également connecté au circuit d'alimentation **150.**

Le circuit d'alimentation **150** permet de sélectionner un niveau d'alimentation de l'étage d'amplification de puissance **204** adapté à la puissance d'amplification demandée. Ainsi, lorsque la tension d'amplification est supérieure à une valeur seuil, le premier bus d'alimentation fort doit être utilisé alors que, lorsque la tension d'amplification est inférieure à cette valeur seuil, un second bus d'alimentation plus faible peut être utilisé. Les phases d'utilisation du bus d'alimentation plus faible permettent d'améliorer le rendement global de l'amplificateur en comparaison des amplificateurs de classes A, B, et AB.

Par ailleurs, le circuit d'alimentation **150** présente une structure indépendante de l'étage de pré-amplification **201** et de l'étage d'amplification de puissance **204.** Dans l'exemple de la figure 3, l'étage d'amplification de puissance **204** comporte un transistor **Q10** dont la base est reliée à l'émetteur du transistor **Q8.** Cette configuration dite de « Darlington » permet d'augmenter le gain en courant. Les émetteurs des transistors **Q8** et **Q10** sont couplés au haut-parleur **R44** par leurs résistances respectives **R16** et **R19.** Ils ont, par exemple, un courant de repos respectif égal à 6 mA pour le transistor **Q8** et égal à 75 mA pour le transistor **Q10.**

L'étage d'amplification de puissance **204** est relié au circuit d'alimentation **150** au niveau des collecteurs des transistors **Q8** et **Q10.** Ce circuit d'alimentation **150** est connecté à deux bus de tensions présentant des niveaux distincts **V+, V++.** Le circuit d'alimentation **150** permet donc de sélectionner l'un ou l'autre de ces niveaux de tension en fonction de l'amplification demandée. Typiquement, un premier bus d'alimentation délivre 65V et un second bus d'alimentation délivre 35V. Le second bus d'alimentation est destiné à être utilisé pour alimenter l'étage d'amplification de puissance **204** lorsque le signal de sortie à générer ne présente pas une tension très importante, typiquement inférieure à 32V.

Du fait du courant relativement faible traversant le transistor **Q8,** typiquement inférieur à 10 % du courant traversant le transistor **Q10,** le collecteur du transistor **Q8** peut être directement relié au premier bus d'alimentation **V++,** sans que cela n'engendre une dissipation de puissance supplémentaire significative. Ce mode de réalisation peut améliorer la stabilité de l'amplificateur, que le fonctionnement en amplificateur de courant a tendance à mettre à mal.

Afin de réaliser la sélection du niveau de tension adapté, un transistor MOSFET **M1** est directement relié au premier bus d'alimentation **V++** par son drain et au second bus d'alimentation **V+** par sa source via une quatrième diode **D3.** Le transistor MOSFET **M1** commute typiquement pour un seuil de 27 V, puis il fonctionne en linéaire au-delà de ce seuil. Il laisse passer le premier bus d'alimentation **V++** lorsqu'une tension de commande supérieure à une valeur seuil lui est appliquée. Cette tension est commandée par l'association de la première diode **D8, D10** connectée entre la grille du transistor MOSFET **M1** et le haut-parleur **R44** et d'une deuxième résistance **R8, R27** connectée entre le drain et la grille du transistor MOSFET **M1.**

Une diode **D15** est connectée entre le collecteur du transistor **Q10** et le haut-parleur **R44,** la cathode de la diode étant reliée au collecteur du transistor **Q10.**

Avec un tel montage, les différents signaux obtenus sont illustrés sur la figure 4.

Ainsi, le signal numéroté **1** sur les figures 3 et 4 représente le signal de grille du transistor MOSFET **M1.** Le signal de sortie numéroté **3** sur les figures 3 et 4 représente le signal de sortie de l'amplificateur, c'est-à-dire le signal aux bornes du haut-parleur **R44.** Le signal de sortie numéroté **2** sur les figures 3 et 4 représente le signal de sortie du circuit d'alimentation **150.** On remarque ainsi que le signal de sortie **3** est déformé. En effet, la crête de la sinusoïde est aplatie et des décrochements ont lieu vers 27µs. Cette saturation du signal de sortie 3 s'explique par le fait que la tension d'alimentation du transistor MOSFET **M1** est insuffisante pour que l'amplificateur puisse délivrer la tension de sortie correctement.

De même, le signal **2** présente, entre 40 et 47µs, un pic anormal de tension correspondant à une surtension au niveau de la grille du transistor MOSFET **M1.** Ceci entraine une perte de puissance et une dégradation du rendement de l'amplificateur.

Le problème technique que se propose de résoudre l'invention est donc d'obtenir un amplificateur audio haute puissance permettant de limiter les déformations identifiées sur les signaux et donc d'améliorer le rendement et de réduire la saturation de l'amplificateur. US3974455 divulgue un amplificateur de puissance audio de classe H selon l'art antérieur.

### EXPOSE DE L'INVENTION

Pour résoudre ce problème, l'invention propose un circuit d'alimentation comportant un transistor MOSFET commandé par un sous-circuit d'aide à la charge, un sous-circuit d'aide à la décharge et un sous-circuit de décalage de tension permettant d'obtenir un meilleur rendement de l'amplificateur tout en limitant les saturations et les déformations du signal de sortie de l'amplificateur.

Autrement formulé, l'invention concerne un amplificateur audio haute puissance destiné à commander au moins un haut-parleur, ledit amplificateur comportant :
- un étage de pré-amplification recevant un signal d'entrée ;
- un étage d'amplification de puissance connecté à l'étage de pré-amplification et fournissant un signal de sortie destiné à alimenter ledit au moins un haut-parleur ; les étages de pré-amplification et d'amplification de puissance comportant une partie supérieure et une partie inférieure montées en miroir ;
- une contre-réaction fournissant à l'étage de pré-amplification une image du signal de sortie,
- un circuit d'alimentation supérieur, connecté à la partie supérieure de l'étage d'amplification de puissance, et permettant de l'alimenter par un premier ou un second bus d'alimentation ;
- un circuit d'alimentation inférieur connecté à la partie inférieure de l'étage d'amplification de puissance et permettant de l'alimenter par un premier ou un second bus d'alimentation ;
- chaque circuit d'alimentation comportant un transistor MOSFET et des moyens de supervision, le transistor MOSFET étant commandé par les moyens de supervision de sorte à réaliser la commutation entre l'un ou l'autre des deux bus d'alimentation, le transistor MOSFET étant relié au second bus d'alimentation par l'intermédiaire d'une quatrième diode dont une première borne est reliée à la source du transistor MOSFET, et le drain du transistor MOSFET étant relié au premier bus d'alimentation.

L'invention se caractérise en ce que chaque circuit d'alimentation comporte en outre :
- un sous-circuit d'aide à la charge dudit transistor MOSFET comportant au moins une première résistance, une première borne de la première résistance étant connectée à la grille du transistor MOSFET et une seconde borne de la première résistance étant connectée à un point d'interconnexion ;
- un sous-circuit d'aide à la décharge dudit transistor MOSFET comportant au moins une deuxième et une troisième résistance et un transistor bipolaire ; la base du transistor bipolaire étant connectée sur une première borne de la troisième résistance, son émetteur étant connecté à la grille du transistor MOSFET et son collecteur étant connecté à la source du transistor MOSFET par l'intermédiaire de la deuxième résistance, la seconde borne de la troisième résistance étant connectée sur le point d'interconnexion ; et
- un sous-circuit de décalage de tension comportant une première diode montée en parallèle avec un premier condensateur ; une première borne de la première diode et une première borne du premier condensateur étant connectés sur un premier nœud d'interconnexion ; une seconde borne de la première diode et une seconde borne du premier condensateur étant connectés sur un second nœud d'interconnexion.

En particulier, le sous-circuit d'aide à la charge permet au transistor MOSFET de se charger plus rapidement. En effet, il comprend tout d'abord la première résistance, qui présente de préférence une résistance de forte valeur afin de ne pas échanger trop d'énergie avec la sortie de l'amplificateur et d'engendrer davantage de distorsion, c'est-à-dire environ 15 kΩ. Cette première résistance ne laisse passer qu'un courant faible pour charger ou décharger la grille du transistor MOSFET. La grille se comportant comme un condensateur, la combinaison du transistor MOSFET avec la première résistance augmente cependant la durée des temps de charge et de décharge.

Le sous-circuit d'aide à la décharge permet au transistor MOSFET de se décharger plus rapidement. Le transistor bipolaire permet notamment de décharger la grille du transistor MOSFET lorsque le signal d'entrée sinusoïdal est sur sa phase décroissante.

Le sous-circuit de décalage de tension fait en sorte que le potentiel de la grille du transistor MOSFET soit toujours plus élevé que celui de la sortie de l'amplificateur. Typiquement, le potentiel de la grille du transistor MOSFET peut être plus élevé de 15 V par rapport à celui de la sortie de l'amplificateur. Le sous-circuit de décalage de tension permet également de compenser les chutes de tensions du transistor MOSFET. Selon un deuxième mode de réalisation, le sous-circuit de décalage de tension comporte en outre au moins une quatrième résistance et une deuxième diode, montées en parallèle.

Une première borne de la deuxième diode et une borne de la quatrième résistance sont reliées au premier nœud d'interconnexion, une seconde borne de la quatrième résistance et une seconde borne de la deuxième diode étant reliée à un troisième nœud d'interconnexion.

L'ajout de ces composants permet de réduire les distorsions observées sur le signal de sortie de l'amplificateur. Cette amélioration de la distorsion est efficace pour un signal sinusoïdal d'entrée, si celui-ci est de fréquence relativement basse, c'est-à-dire environ 1 kHz.

Avantageusement, selon un troisième mode de réalisation, le sous-circuit d'aide à la charge comporte en outre une cinquième résistance montée en série avec une troisième diode, la cinquième résistance et la troisième diode étant montées en parallèle de la branche du sous-circuit d'aide à la charge incluant la première résistance.

La troisième diode, montée en parallèle de la première résistance, permet de laisser passer le courant destiné à charger la grille du transistor MOSFET et de bloquer le courant destiné à décharger la grille du transistor MOSFET. La cinquième résistance est de préférence de valeur faible, c'est-à-dire environ 300 Ω. Cette cinquième résistance permet de charger beaucoup plus rapidement la grille du transistor MOSFET, puisque la constante de temps de chargement est égale au produit de la résistance par la capacité. L'ajout de ces composants permet ici encore d'améliorer la distorsion pour un signal sinusoïdal d'entrée allant jusqu'à une fréquence de 20kHz. La distorsion est donc améliorée sur l'entièreté du spectre sonore. La restitution sonore d'un haut-parleur branché sur l'amplificateur de l'invention est donc améliorée. L'auditeur perçoit moins de distorsions en comparaison des amplificateurs de l'art antérieur.

Selon un quatrième mode de réalisation, le sous-circuit de décalage de tension comporte en outre un deuxième condensateur et un troisième condensateur, le deuxième condensateur étant monté en parallèle du premier condensateur et de la première diode et le troisième condensateur étant monté en parallèle de la troisième diode et de la cinquième résistance. Ces composants supplémentaires permettent de limiter les perturbations, c'est-à-dire les signaux parasites venant se superposer au signal de sortie attendu.

En pratique, chaque circuit d'alimentation comporte une première diode de protection dont une première borne est connectée à la source du transistor MOSFET et dont une seconde borne est connectée à la grille du transistor MOSFET. De même, chaque circuit d'alimentation comporte en outre une seconde diode de protection connectée entre la source et le drain du transistor MOSFET.

La première diode de protection est ajoutée afin de protéger le transistor MOSFET des surtensions sur sa grille, qui pourraient l'endommager voire le rendre inutilisable, en rompant l'isolation entre la grille et le canal qui ne peut supporter que +/- 20V en continu et +/- 30V de façon transitoire.

La seconde diode de protection a pour rôle de protéger le transistor MOSFET d'une tension drain-source inverse qui pourrait survenir si la tension du premier bus d'alimentation n'apparaît qu'après celle du second bus d'alimentation. Les différents bus d'alimentation ont chacun leurs enroulements de transformateur et leurs condensateurs de lissage, d'où des constantes de temps différentes.

Selon un cinquième mode de réalisation, chaque circuit d'alimentation comporte en outre un condensateur monté en parallèle de la quatrième diode. Ce condensateur permet d'éliminer les pics parasites générés par la diode dont une première borne est reliée à la source du transistor MOSFET, lorsque cette dernière commute. Le taux de distorsion par harmoniques (THD) est également amélioré. Ce taux est une mesure de la linéarité du traitement effectuée. Il est calculé en comparant le signal en sortie d'un appareil à un signal d'entrée parfaitement sinusoïdal.

En pratique, l'étage de pré-amplification est connecté au premier bus d'alimentation de chaque circuit d'alimentation par le biais d'un circuit d'amortissement des variations de puissance dudit premier bus d'alimentation, ledit circuit d'amortissement des variations de puissance comportant au moins un condensateur et au moins une résistance montés en filtre passe-bas. Autrement formulé, la résistance est connectée en série avec le condensateur, qui est lui connecté à la masse.

Ce montage permet d'isoler du bruit et des creux de tension. Ce phénomène survient notamment lorsque l'amplificateur haute-tension délivre un courant élevé. Le condensateur joue alors un rôle de réservoir d'énergie.

Avantageusement, ledit circuit d'amortissement des variations de puissance comporte en outre un condensateur supplémentaire monté en parallèle de l'au moins un condensateur. Le condensateur monté en parallèle présente une valeur plus modeste, typiquement inférieure d'un facteur 10³. Il permet de supprimer les parasites en haute-fréquence.

Selon un mode de réalisation spécifique de l'invention, la contre-réaction appliquée à l'étage de pré-amplification fournit un signal proportionnel au courant traversant le haut-parleur. Ce mode de réalisation permet d'obtenir un amplificateur haute-puissance en courant. Tel que décrit en référence à la figure 2 de l'état de la technique, cette catégorie d'amplificateurs haute-puissance en courant présente la même topologie que pour les amplificateurs haut-puissance en tension, à savoir un étage de pré-amplification couplé à un étage d'amplification. Cependant, la contre réaction appliquée à l'étage de pré-amplification diffère.

En utilisant le circuit d'alimentation de l'invention pour un amplificateur haute-puissance en courant, l'amplificateur haute-puissance en courant présente une consommation très limitée.

En effet, lorsque l'amplificateur délivre en sortie une tension faible, le circuit d'alimentation de l'invention ne sera pas actif. Ainsi, la puissance fournie par l'alimentation sera égale au produit du courant de sortie multiplié par la tension délivrée par le bus d'alimentation de plus faible puissance, au lieu de la tension maximale délivrée par l'unique bus d'alimentation pour un amplificateur de classe AB standard. A puissance égale, et en supposant par exemple que la tension délivrée par le bus d'alimentation de plus faible puissance soit égale à la moitié de celle du bus d'alimentation de plus grande puissance, deux fois moins de puissance sera fournie par l'alimentation. Les transistors, qui dissipent la différence entre la puissance fournie par l'alimentation et la puissance fournie au haut-parleur, chaufferont nettement moins.

### BRÈVE DESCRIPTION DES FIGURES

La manière de réaliser l'invention, ainsi que les avantages qui en découlent, ressortiront bien de la description des modes de réalisation qui suivent, à l'appui des figures annexées dans lesquelles :
[Fig 1] est un schéma électrique d'un amplificateur haute-puissance en tension de l'art antérieur,
[Fig 2] est un schéma électrique d'un amplificateur haute-puissance en courant de l'art antérieur,
[Fig 3] est un schéma électrique d'un amplificateur haute-puissance en tension de l'art antérieur comportant un étage d'alimentation,
[Fig 4] est un graphique représentant l'évolution de la tension de la grille du transistor MOSFET, de la tension de sortie de l'amplificateur, et du signal de sortie du circuit d'alimentation pour le circuit de la figure 3.
[Fig 5a] et [Fig 5b] est un schéma électrique de l'amplificateur haute-puissance en tension selon un mode de réalisation de l'invention,
[Fig 6] est un schéma électrique du circuit d'alimentation de l'amplificateur haute-puissance selon un deuxième mode de réalisation,
[Fig 7] est un graphique représentant l'évolution de la tension de la grille du transistor MOSFET, de la tension de sortie de l'amplificateur, et du signal de sortie du circuit d'alimentation pour le circuit de la figure 6 avec en entrée une sinusoïde de fréquence 20kHz,
[Fig 8] est un graphique représentant l'évolution de la tension de la grille du transistor MOSFET, de la tension de sortie de l'amplificateur, et du signal de sortie du circuit d'alimentation pour le circuit de la figure 6 avec en entrée une sinusoïde de fréquence 1kHz,
[Fig 9] est un schéma électrique du circuit d'alimentation de l'amplificateur haute-puissance selon un troisième mode de réalisation,
[Fig 10] est un graphique représentant l'évolution de la tension de la grille du transistor MOSFET, de la tension de sortie de l'amplificateur, et du signal de sortie du circuit d'alimentation pour le circuit de la figure 9 avec en entrée une sinusoïde de fréquence 20kHz,
[Fig 11] est un graphique représentant l'évolution de la tension de la grille du transistor MOSFET, de la tension de sortie de l'amplificateur, et du signal de sortie du circuit d'alimentation pour le circuit de la figure 9 avec en entrée une sinusoïde de fréquence 1kHz,
[Fig 12] est un schéma électrique du circuit d'alimentation de l'amplificateur haute-puissance selon un quatrième mode de réalisation,
[Fig 13] est un graphique représentant l'évolution de la tension de la grille du transistor MOSFET, de la tension de sortie de l'amplificateur, et du signal de sortie du circuit d'alimentation pour le circuit de la figure 12 avec en entrée une sinusoïde de fréquence 20kHz,
[Fig 14] est un schéma électrique du circuit d'alimentation de l'amplificateur haute-puissance selon un cinquième mode de réalisation,
[Fig 15] est un graphique représentant l'évolution de la tension de la grille du transistor MOSFET, de la tension de sortie de l'amplificateur, et du signal de sortie du circuit d'alimentation pour le circuit de la figure 14 avec en entrée une sinusoïde de fréquence 20kHz,
[Fig 16] est un schéma électrique du circuit d'alimentation de l'amplificateur haute-puissance selon le premier mode de réalisation de la figure 5,
[Fig 17] est un graphique représentant l'évolution de la tension de la grille du transistor MOSFET, de la tension de sortie de l'amplificateur, et du signal de sortie du circuit d'alimentation pour le circuit de la figure 16 avec en entrée une sinusoïde de fréquence 20kHz,
[Fig 18a] et [Fig 18b] est un schéma électrique de l'amplificateur haute-puissance en courant selon un mode de réalisation de l'invention, et
[Fig 19] est un schéma électrique d'une structure de protection d'un amplificateur haute-puissance en courant selon un mode de réalisation de l'invention.

### DESCRIPTION DÉTAILLÉE DES MODES DE RÉALISATION

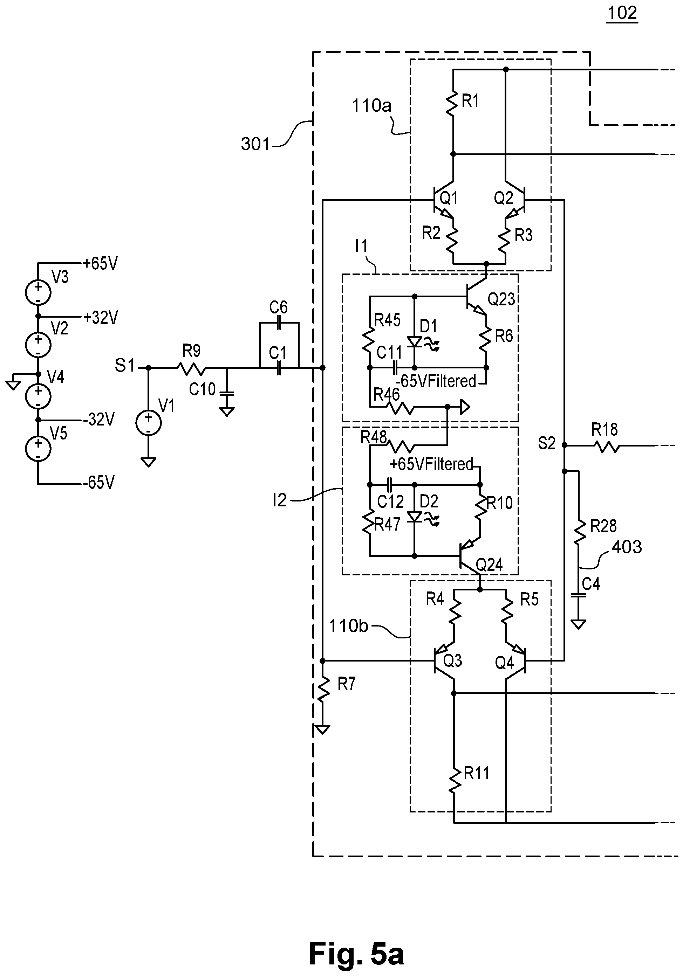

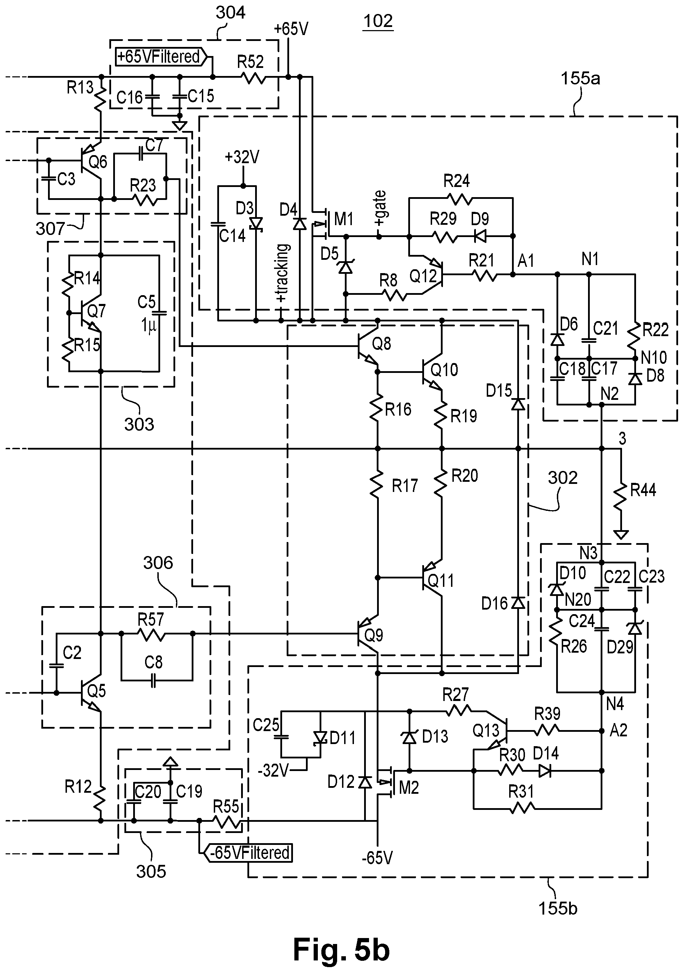

Tel qu'illustré sur la figure 5a-5b, l'amplificateur haute-puissance **102** de l'invention est symétrique, il comporte une partie supérieure, qui amplifie l'alternance positive du signal d'entrée **S1** et une partie inférieure, qui amplifie l'alternance négative du signal d'entrée **S1.**

L'amplificateur haute-puissance **102** comporte un étage de pré-amplification recevant le signal d'entrée **S1** et fournissant des signaux provenant du collecteur des transistors **Q5, Q6,** par l'intermédiaire d'un réseau constitué de la résistance **R23, R57,** montée en parallèle avec un condensateur **C7, C8.** Ces signaux sont fournis à un étage d'amplification de puissance **302** sur la base du transistor **Q8, Q9.** Ce dernier fournit un signal de sortie **3** destiné à alimenter un haut-parleur **R44.** Une contre-réaction fournit à l'étage de pré-amplification **201** une image du signal de sortie **3.**

L'amplificateur haute-puissance **102** comporte également un circuit d'alimentation supérieur **155a,** connecté à la partie supérieure de l'étage d'amplification de puissance **302,** et un circuit d'alimentation inférieur **155b** connecté à la partie inférieure de l'étage d'amplification de puissance **302.**

L'étage de pré-amplification **301** comporte deux paires différentielles **110a, 110b** comprenant chacune deux transistors **Q1, Q2** et **Q3, Q4** montés en miroir l'un de l'autre. Ainsi, l'émetteur des transistors **Q1, Q2** est relié au bus d'alimentation en - 65V par l'intermédiaire d'une résistance **R2, R3** et d'une première source de courant constant **I1,** tandis que l'émetteur des transistors **Q3, Q4** est relié au bus d'alimentation en + 65V par l'intermédiaire d'une résistance **R4, R5** et d'une seconde source de courant de même valeur **I1.**

Les sources de courant **I1** et **I2** comprennent chacune un transistor **Q23, Q24** dont le collecteur est respectivement relié aux résistances **R2, R3** et **R4, R5.** L'émetteur des transistor **Q23, Q24** est connecté à une résistance **R6, R10.** La seconde borne de la résistance **R6** est connectée d'une part au bus d'alimentation en - 65V et d'autre part à la masse, par l'intermédiaire d'un condensateur **C11** monté en série avec une résistance **R46.** La seconde borne de la résistance **R10** est connectée d'une part au bus d'alimentation en + 65V et d'autre part à la masse, par l'intermédiaire d'un condensateur **C12** monté en série avec une résistance **R48.**

Une diode **D1, D2** est montée entre la base du transistor **Q23, Q24** et la seconde borne de la résistance **R6, R10,** tandis qu'une résistance **R45, R47** est montée entre la base du transistor **Q23, Q24** et le point d'interconnexion entre le condensateur **C11, C12** et la résistance **R46, R48.**

Le collecteur des transistors **Q2, Q4** peut être directement relié, respectivement, au bus d'alimentation en +65V et en -65V. En variante, le collecteur des transistors **Q2, Q4** peut être relié, respectivement, au bus d'alimentation en +65V et en -65V par l'intermédiaire d'un circuit d'amortissement des variations de puissance **304, 305.**

Le circuit d'amortissement des variations de puissance **304, 305** comporte une résistance **R52, R55** montée en série avec un condensateur **C15, C19** connecté à la masse. La seconde borne de la résistance **R52, R55** est connectée au bus d'alimentation en +/-65V. Avantageusement, un autre condensateur **C16, C20** peut être monté en parallèle du condensateur **C15, C19.** En pratique, le condensateur **C15, C19** présente une valeur comprise entre 150 et 300 µF, tandis que le condensateur **C16, C20** présente une valeur comprise entre 150 et 300 nF.

Le collecteur des transistors **Q1, Q3** est respectivement relié au bus d'alimentation en +65V et en -65V par l'intermédiaire d'une résistance **R1, R11** et avantageusement par l'intermédiaire du circuit d'amortissement des variations de puissance **304, 305.** En l'absence de contre-réaction, le gain du premier étage de pré-amplification **102** dépend du rapport des résistances **R1/R2** et **R11/R4.**

Les bases des transistors **Q1** et **Q3** sont reliées entre elles et connectées à la masse par l'intermédiaire d'une résistance **R7.** Les bases des transistors **Q2** et **Q4** sont également reliées entre-elles. Les bases des transistors **Q1** et **Q3** sont alimentées par le signal d'entrée **S1.** La source de tension **V1,** connectée entre le point **S1** et la masse représente le générateur du signal d'entrée **S1.** Un circuit intermédiaire de filtrage peut être intercalé entre le signal d'entrée **S1** et les bases des transistors **Q1** et **Q3.** Ce circuit comporte par exemple un filtre passe-bande comportant une résistance **R9** et un condensateur **C10** connecté à la masse, et deux condensateurs **C1, C6,** montés en parallèle.

Les bases des transistors **Q2** et **Q4** sont reliées au haut-parleur **R44** par l'intermédiaire d'une résistance **R18,** de sorte à former la contre-réaction appliquée sur l'étage de pré-amplification **301.** Les collecteurs des transistors **Q1** et **Q3** assurent le couplage de l'étage de pré-amplification **301** avec les circuits **306, 303, 307** et les résistances **R12, R13.**

L'étage d'amplification de puissance **302** comporte deux transistors **Q8, Q9** reliés par leur base respective à l'étage de pré-amplification **301** par l'intermédiaire du circuit **306, 307.**

Le circuit **306, 307** comporte un transistor **Q5, Q6** dont l'émetteur est relié au bus de tension en +/-65V par l'intermédiaire d'une résistance **R12, R13** et dont la base est connectée au niveau du collecteur des transistors **Q1, Q3.** Un condensateur **C2, C3** est connecté entre la base et le collecteur des transistors **Q5, Q6** afin d'améliorer la stabilité de l'amplificateur. Le collecteur des transistors **Q5, Q6** est relié d'une part à une résistance **R57, R23** montée en parallèle avec un condensateur **C8, C7** et d'autre part, à un circuit de polarisation **303.** Ce dernier comporte un transistor **Q7** dont l'émetteur est relié au collecteur du transistor **Q5** et dont le collecteur est relié au collecteur du transistor **Q6.** Une résistance **R14** est montée entre le collecteur et la base du transistor **Q7** et une autre résistance **R15** est montée entre l'émetteur et la base du transistor **Q7.** Enfin, un condensateur **C5,** présentant par exemple une valeur de 1µF, est connecté entre l'émetteur et le collecteur du transistor **Q7.** Ce condensateur **C5** améliore la stabilité de l'amplificateur. En variante, la résistance **R13, R12** peut être reliée, respectivement, au bus d'alimentation en +65V et en -65V par l'intermédiaire d'un circuit d'amortissement des variations de puissance **304, 305.**

Les circuits **306, 307** réalisent une seconde amplification en tension. Le gain de cette amplification est proportionnel au rapport de la résistance « vue par le collecteur » par celle présente sur l'émetteur de **Q5, Q6.** Lorsque l'un des transistors **Q5, Q6** conduit, son dual est bloqué, le transistor qui est passant voit donc une très forte résistance d'où un gain en tension très conséquent.

L'étage d'amplification de puissance **302** comporte en outre deux transistors **Q10, Q11** dont les bases sont respectivement reliées à l'émetteur des transistors **Q8** et **Q9.** Cette configuration dite de « Darlington » permet d'augmenter le gain en courant. Les émetteurs des transistors **Q8** et **Q10** sont couplés au haut-parleur **R44** par leurs résistances respectives **R16** et **R19,** tandis que les émetteurs des transistors **Q9** et **Q11** sont couplés au haut-parleur **R44** par leurs résistances respectives **R17** et **R20.** Ils ont par exemple un courant de repos respectif égal à 6 mA pour les transistors **Q8, Q9** et égale à 75 mA pour les transistors **Q10, Q11.**

L'étage d'amplification de puissance **302** est relié à deux circuits d'alimentation **155a, 155b** au niveau des collecteurs des transistors **Q8-Q11.** Ces circuits d'alimentation **155a, 155b** sont connectés à deux bus de tensions présentant des niveaux distincts **V+, V++.** Le circuit d'alimentation **155a, 155b** permet donc de sélectionner l'un ou l'autre de ces niveaux de tension en fonction de l'amplification demandée. Typiquement, un premier bus d'alimentation délivre +/-65V et un second bus d'alimentation délivre +/ 32V. Le second bus d'alimentation est destiné à être utilisé pour alimenter l'étage d'amplification de puissance **302** lorsque le signal de sortie à générer ne présente pas une tension très importante, typiquement inférieure à 27V. Du fait du courant relativement faible traversant les transistors **Q8** et **Q9,** typiquement inférieur à 10 % du courant traversant les transistors **Q10** et **Q11,** les collecteurs de **Q8** et **Q9** peuvent être directement reliés au premier bus d'alimentation V++ sans que cela n'engendre une dissipation de puissance supplémentaire significative. Ce mode de réalisation améliore la stabilité de l'amplificateur au niveau de sa marge de phase et de sa marge de gain.

En outre, les bases des transistors **Q2** et **Q4** sont reliées à une ligne de protection comportant une résistance **R28** montée en série avec un condensateur **C4** connecté à la masse. Ce montage est un diviseur de tension. En pratique, le condensateur **C4** se comporte comme un court-circuit lorsque la tension parcourant le circuit est alternative. En revanche, lorsque la tension parcourant le circuit est continue, le condensateur **C4** se comporte comme un circuit ouvert. Dans ce cas, la sortie de l'amplificateur haute-puissance **100** est directement reliée au point **S2.** Le gain en tension de l'amplificateur haute-puissance **100** est alors égal à 1, ce qui permet de limiter une éventuelle composante continue indésirable sur la tension appliquée aux bornes du haut-parleur **R44.**

Plusieurs modes de réalisations sont possibles pour le circuit d'alimentation **151-155, 155a, 155b.**

Pour tous les modes de réalisation qui suivent, le signal numéroté **1** représente le signal de grille du transistor MOSFET **M1, M2.** Le signal de sortie numéroté **3** représente le signal de sortie de l'amplificateur, c'est-à-dire le signal aux bornes du haut-parleur **R44.** Le signal de sortie numéroté **2** représente le signal de sortie du circuit d'alimentation **151-155, 155a, 155b,** c'est-à-dire le signal présent sur le collecteur des transistors **Q8** et **Q10.**

Dans la suite de la description, seul le circuit d'alimentation supérieur est illustré mais la figure 5a-5b permet de comprendre le positionnement des composants correspondants pour le circuit d'alimentation inférieur.

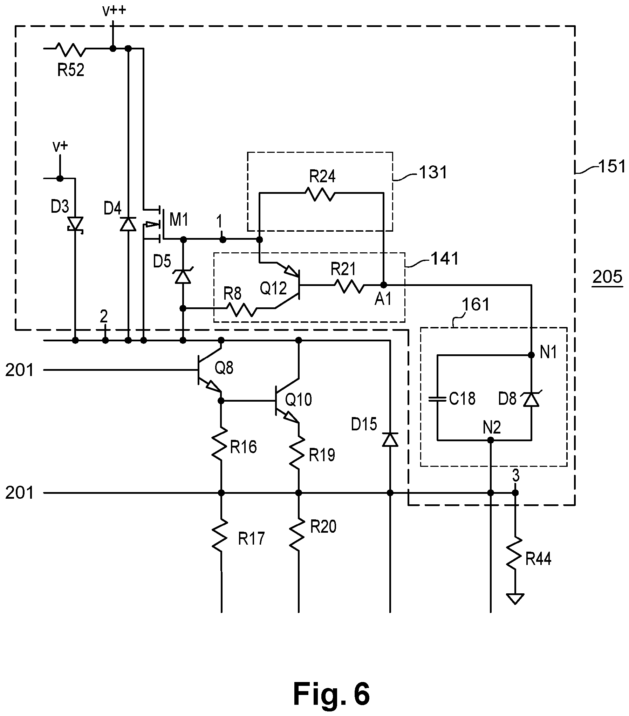

Tel qu'illustré sur la figure 6, dans un premier mode de réalisation, le circuit d'alimentation **151** comporte un transistor MOSFET **M1, M2** directement relié au premier bus d'alimentation **V++** par son drain et au second bus d'alimentation **V+** par sa source via une quatrième diode **D3, D11,** qui peut être une diode classique ou une diode schottky. En pratique, l'anode de la quatrième diode **D3** est connectée au second bus d'alimentation **V+** et sa cathode au signal de sortie numéroté **2** représentant le signal de sortie du circuit d'alimentation **151-155, 155a, 155b** ; la cathode de la quatrième diode **D11** est connectée au second bus d'alimentation **-V+.** Le transistor MOSFET **M1, M2** est bloqué pour une tension inférieure à un seuil, typiquement de 35 V, puis commute et fonctionne en linéaire au-delà de ce seuil. Le transistor MOSFET **M1, M2** laisse passer le premier bus d'alimentation **V++** lorsqu'une tension de commande supérieure à la valeur seuil lui est appliquée. Cette tension est commandée par l'association d'un sous-circuit d'aide à la charge **131,** d'un sous-circuit d'aide à la décharge **141** et d'un sous-circuit de décalage de tension **161.**

Le sous-circuit d'aide à la charge **131** comporte une première résistance **R24, R31** connectée entre la grille du transistor MOSFET **M1, M2** et un point d'interconnexion **A1, A2.**

Le sous-circuit d'aide à la décharge **141** comporte un transistor **Q12, Q13** dont l'émetteur est connecté d'une part à la grille du transistor MOSFET **M1, M2** et d'autre part au sous-circuit d'aide à la charge **131.** Le collecteur du transistor **Q12, Q13** est connecté au signal de sortie **2** du circuit d'alimentation **151** par l'intermédiaire de la deuxième résistance **R8, R27.** La base du transistor **Q12, Q13** est reliée au point d'interconnexion **A1, A2** par l'intermédiaire d'une troisième résistance **R21, R39.**

Le sous-circuit de décalage de tension **161** comporte un premier condensateur **C18, C23** monté en parallèle d'une première diode **D8, D10.** La cathode de la première diode **D8** est connectée à un premier nœud d'interconnexion **N1** et l'anode de la première diode **D8** est connectée à un second nœud d'interconnexion **N2.** La diode **D10** est connectée en sens inverse, c'est-à-dire que sa cathode est connectée au nœud d'interconnexion **N3** et son anode est connectée au nœud d'interconnexion **N4,** tel qu'illustré sur la figure 5a-5b. Le premier nœud d'interconnexion est relié au point d'interconnexion **A1** et le second nœud d'interconnexion est relié au haut-parleur **R44.**

Le sous-circuit de décalage de tension fait en sorte que le potentiel de la grille du transistor MOSFET **M1** soit toujours plus élevé de 15 V par rapport à celui de la sortie de l'amplificateur.

En outre, le montage de type Darlington constitué par les transistors **Q8** et **Q10** nécessite 5 V de tension de déchet, c'est-à-dire la tension égale à la différence entre la tension d'entrée sur le collecteur du transistor **Q8** et la tension de sortie de l'émetteur du transistor **Q10.** Le MOSFET **M1,** quant à lui, nécessite 10 V de tension de déchet ; c'est-à-dire la tension égale à la différence entre la tension d'entrée sur sa grille et la tension de sortie sur sa source dans le cas où le courant est maximal et en étant saturé. Le sous-circuit de décalage en tension doit donc compenser les chutes de tensions des deux transistors bipolaires **Q8** et **Q10,** ainsi que du MOSFET **M1** soit 5 + 10 = 15 V.

Le circuit d'alimentation **151** comporte avantageusement une première diode de protection **D5, D13.** L'anode de la diode **D5** est connectée au signal de sortie **2** du circuit d'alimentation **151** et sa cathode est connectée à la grille du transistor MOSFET **M1.** La cathode de la diode **D13** est connectée à la sortie du circuit d'alimentation **155b** et son anode est connectée à la grille du transistor MOSFET **M2.** De même, le circuit d'alimentation **151** comporte une deuxième diode de protection **D4, D12.** La cathode de la diode **D4** est connectée au drain du transistor MOSFET **M1** et son anode est connectée à la source du transistor MOSFET **M1.** La cathode de la diode **D12** est connectée à la source du transistor MOSFET **M2** et son anode est connectée au drain du transistor MOSFET **M2.**

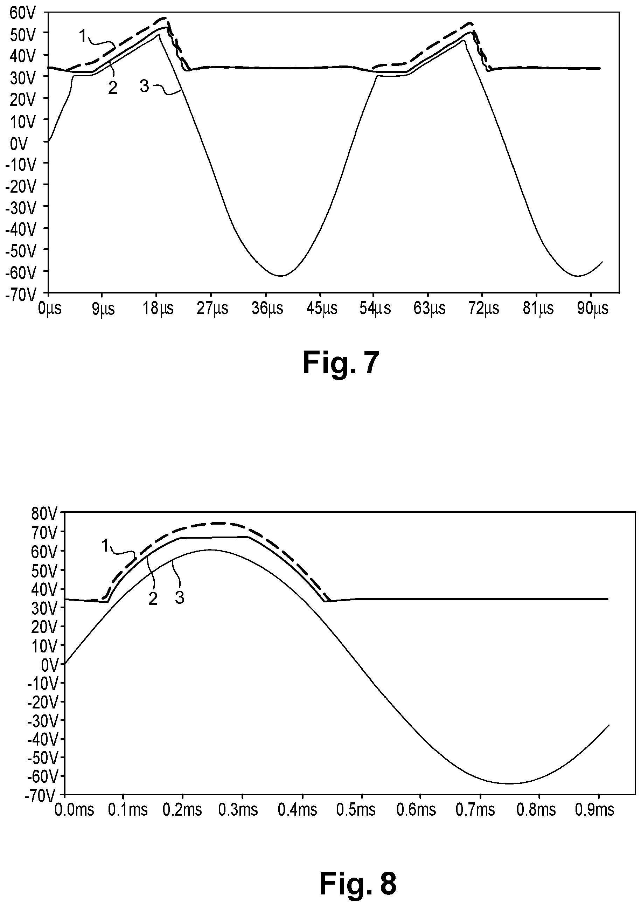

Avec un tel montage, les différents signaux obtenus sont illustrés sur les figures 7 et 8. Les signaux illustrés sur la figure 7 correspondent aux signaux obtenus avec une sinusoïde de fréquence 20kHz fournie en entrée de l'amplificateur haute-puissance **102.** On remarque ainsi que le signal de sortie **3** est déformé au niveau des sommets des sinusoïdes qui prennent un aspect triangulaire. Ainsi, il n'est pas possible de reproduire correctement une sinusoïde à 20 kHz. En revanche, on n'observe pas de pics anormaux de tension. Les pertes de puissance sont donc limitées.

Les signaux illustrés sur la figure 8 correspondent aux signaux obtenus avec une sinusoïde de fréquence 1kHz fournie en entrée de l'amplificateur haute-puissance **102.** On remarque ainsi que le signal de sortie **3** est moins déformé qu'à 20kHz. A l'œil nu, la sinusoïde du signal de sortie **3** semble même parfaitement reproduite. Il s'avère cependant que le taux de distorsion par harmoniques (THD) est supérieur à 0,1%.

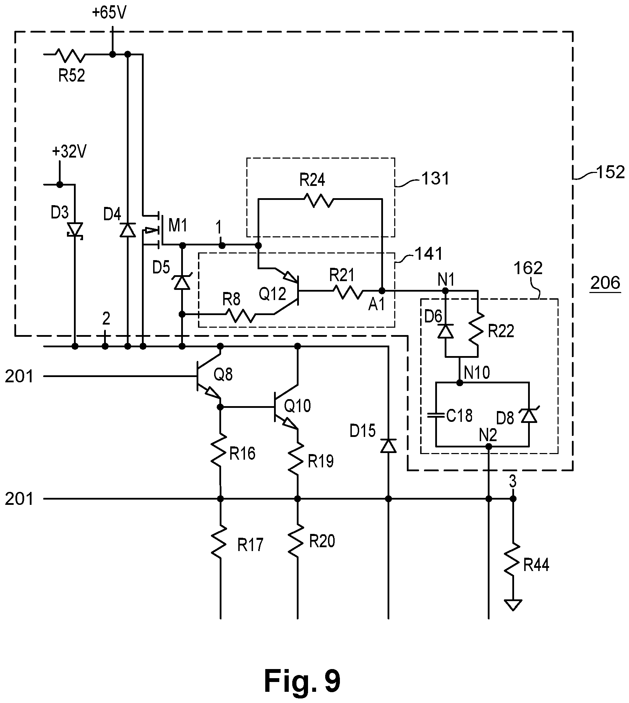

Tel qu'illustré sur la figure 9, dans un deuxième mode de réalisation, le sous-circuit de décalage de tension **162** de l'étage d'alimentation **152** comporte en outre une deuxième diode **D6, D29** montée en parallèle avec une quatrième résistance **R22, R26.** La cathode de la deuxième diode **D6** est connectée au point d'interconnexion **N1** et l'anode de la deuxième diode **D6** est connecté au troisième nœud d'interconnexion **N10.** La diode **D29** est connectée en sens inverse, c'est-à-dire que sa cathode est connectée au nœud d'interconnexion **N20** et son anode est connectée au nœud d'interconnexion **N4,** tel qu'illustré sur la figure 5a-5b.

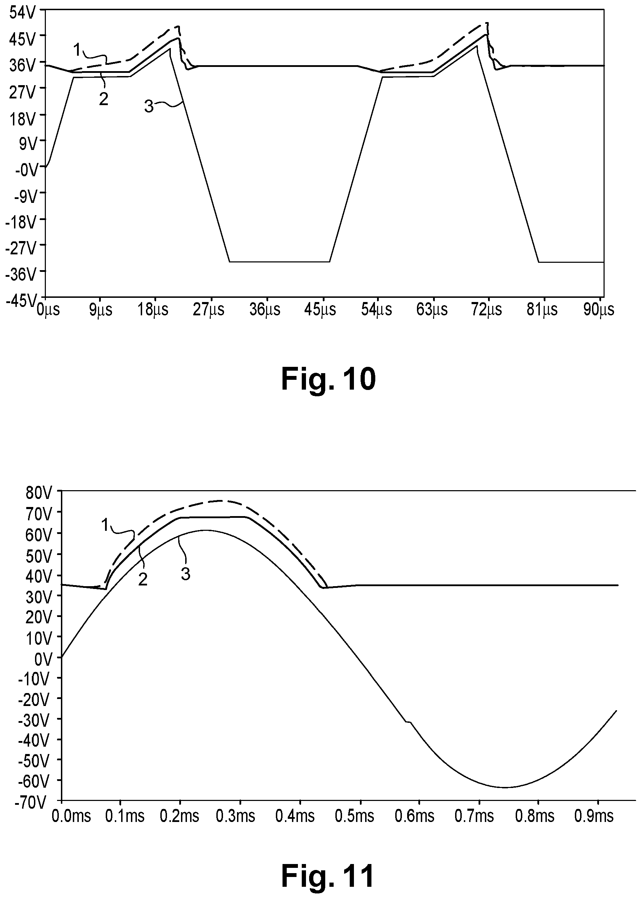

Avec un tel montage, les différents signaux obtenus sont illustrés sur les figures 10 et 11. Les signaux illustrés sur la figure 10 correspondent aux signaux obtenus avec une sinusoïde de fréquence 20kHz fournie en entrée de l'amplificateur haute-puissance **102.** On observe toujours que le signal de sortie **3** est déformé au niveau des sommets des sinusoïdes, qui prennent un aspect triangulaire. Ainsi, il n'est toujours pas possible de reproduire correctement une sinusoïde à 20 kHz.

Les signaux illustrés sur la figure 11 correspondent aux signaux obtenus avec une sinusoïde de fréquence 1kHz fournie en entrée de l'amplificateur haute-puissance **102.** A l'œil nu, la sinusoïde du signal de sortie **3** semble parfaitement reproduite sur l'alternance positive et légèrement déformée sur l'alternance négative. La distorsion par harmoniques THD est égale à 0,45 % car la déformation observée correspond à la production d'harmoniques.

L'ajout de ces composants ne permet donc pas de réduire les distorsions observées sur le signal de sortie de l'amplificateur. L'ajout de la deuxième diode **D6, D29** et de la quatrième résistance **R22, R26** dégrade la performance dynamique du circuit. Il faut une circuiterie plus complexe pour que ces composants soient bénéfiques, c'est-à-dire qu'ils améliorent les dégradations en basses fréquences et en hautes fréquences. Pour obtenir un gain de performance, il est possible d'ajouter d'autres éléments autour du transistor **Q12, Q13.**

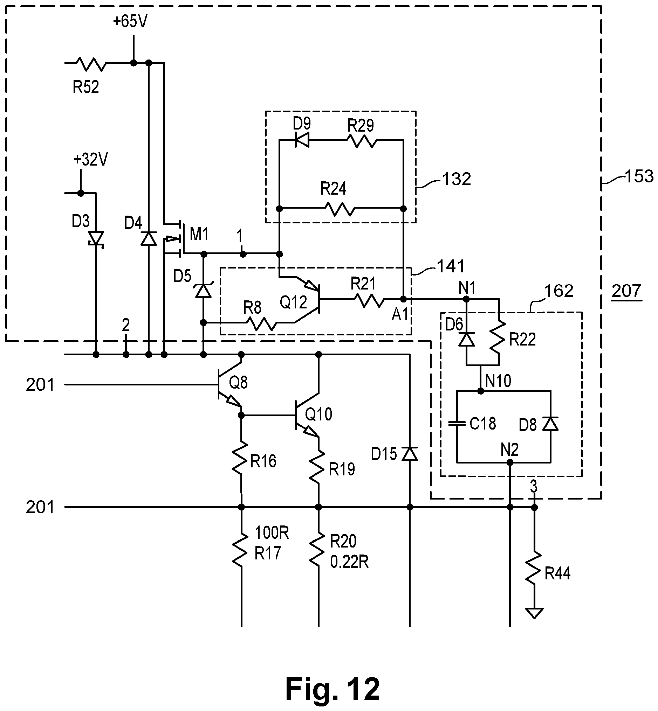

Tel qu'illustré sur la figure 12, dans un troisième mode de réalisation, le sous-circuit d'aide à la charge **132** de l'étage d'alimentation **153** comporte en outre une branche de circuit comprenant une troisième diode **D9, D14** en série avec une cinquième résistance **R29, R30,** montée en parallèle de la première résistance **R24, R31.** La cathode de la troisième diode **D9** est par exemple reliée à la grille du transistor MOSFET **M1.** L'anode de la troisième diode **D14** est reliée à la grille du transistor MOSFET **M2.** En variante, les composants **D9, R29** et **D14, R30** peuvent être inversés, de telle sorte que la troisième diode **D9, D14** est connectée à la grille du transistor MOSFET **M1, M2** par l'intermédiaire de la résistance **R29, R30.**

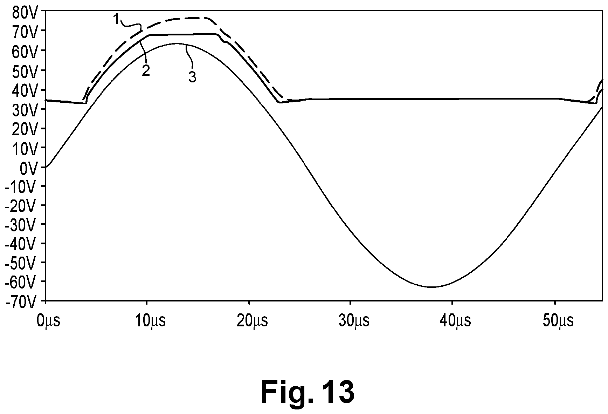

Avec un tel montage, les différents signaux obtenus sont illustrés sur la figure 13. Ces derniers correspondent aux signaux obtenus avec une sinusoïde de fréquence 20kHz fournie en entrée de l'amplificateur haute-puissance **102.**

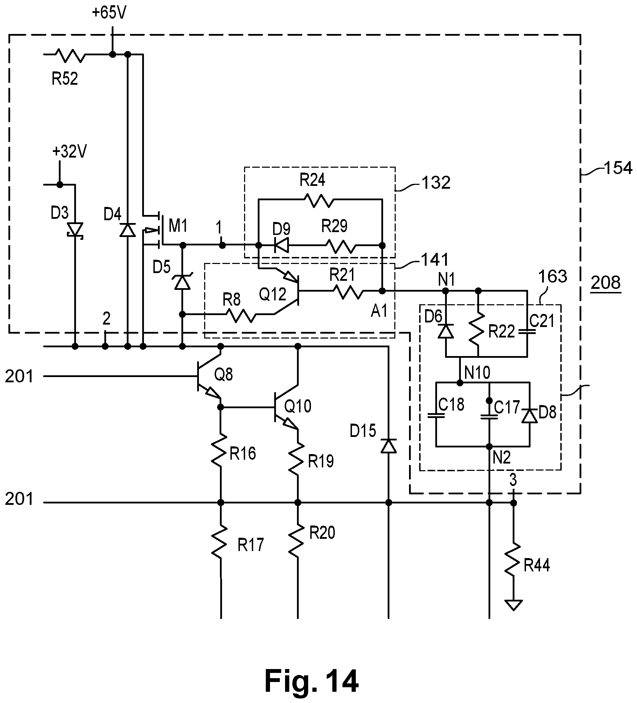

On observe que la sinusoïde de sortie correspondant au signal de sortie numéroté **3** est bien restituée. En revanche, le signal de sortie **2,** représentant la tension de sortie du circuit d'alimentation **153,** présente des déformations entre 0 et 5µs et entre 18 et 20µs. Le taux de THD est égal à 0.26%. L'ajout de ces composants permet ici d'améliorer la distorsion pour un signal sinusoïdal d'entrée allant jusqu'à une fréquence de 20kHz. Tel qu'illustré sur la figure 14, dans un quatrième mode de réalisation, le sous-circuit de décalage de tension de l'étage d'alimentation **154** comporte en outre un troisième condensateur **C21, C24** monté en parallèle de la quatrième résistance **R22, R26** et de la deuxième diode **D6, D29,** ainsi qu'un deuxième condensateur **C17, C22,** monté en parallèle de la première diode **D8, D10** et du premier condensateur **C18, C23.**

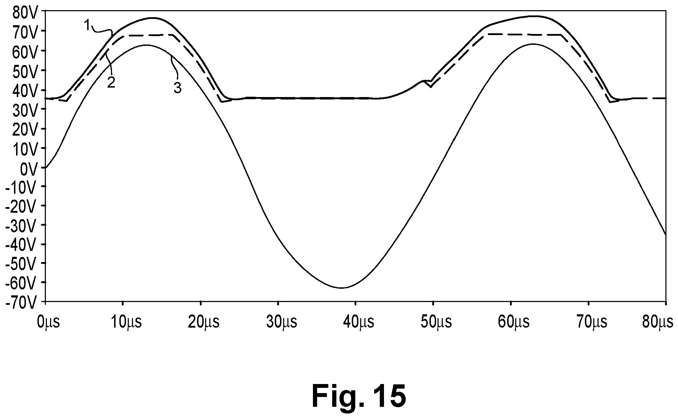

Avec un tel montage, les différents signaux obtenus sont illustrés sur la figure 15. Ces derniers correspondent aux signaux obtenus avec une sinusoïde de fréquence 20kHz fournie en entrée de l'amplificateur haute-puissance **102.**

On observe ainsi que le signal **2** est moins perturbé mais la commutation de la quatrième diode **D3** génère toujours des parasites, notamment entre 45 et 50µs.

En effet, le deuxième condensateur **C17, C22,** par exemple utilisant la technologie électrochimique, présente une valeur importante, typiquement comprise entre 5 et 15µF, constitue un réservoir d'énergie, tandis que le premier condensateur **C18, C23,** par exemple utilisant la technologie à film plastique, présente une valeur plus faible, typiquement comprise entre 50 et 150nF, permet de lisser les parasites en haute-fréquences. La THD est réduite à 0,21 %

Cette association permet de rendre le circuit plus performant dans les phases transitoires de croissance et de décroissance du signal.

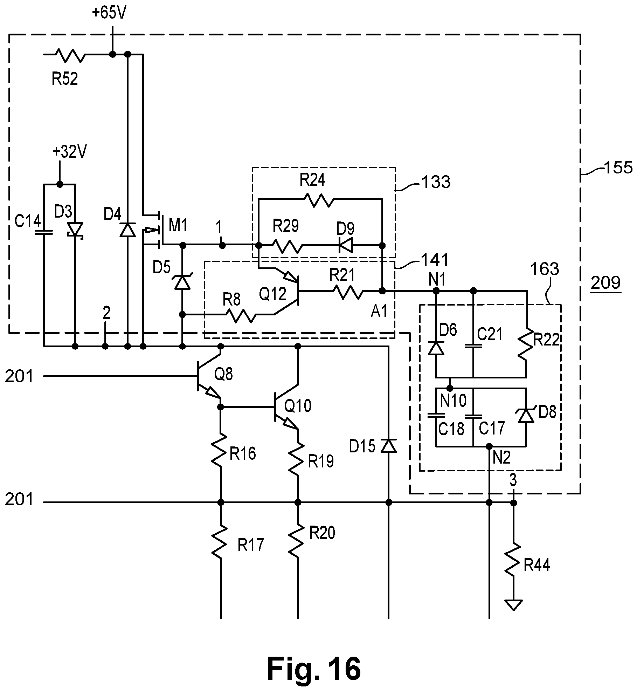

Tel qu'illustré sur les figures 5a-5b et 16, dans un cinquième mode de réalisation, l'étage d'alimentation **155, 155a, 155b** comporte en outre un quatrième condensateur **C14, C25** monté en parallèle de la quatrième diode **D3, D11.**

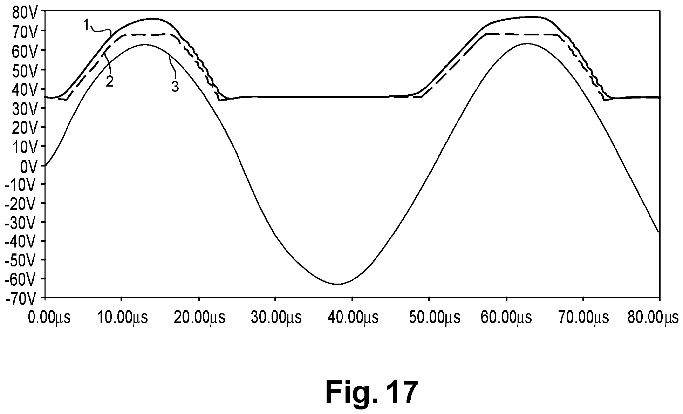

Avec un tel montage, les différents signaux obtenus sont illustrés sur la figure 17. Ces derniers correspondent aux signaux obtenus avec une sinusoïde de fréquence 20kHz fournie en entrée de l'amplificateur haute-puissance **102.**

On observe que les parasites générés par la quatrième diode **D3, D11** ont disparu entre 45 et 50µs. Ceci se traduit par une légère baisse de la THD de 0,21 à 0,2 %.

Bien que l'invention soit précédemment décrite en référence aux figures 5a-5b à 17 pour un amplificateur audio haute puissance **102** permettant d'alimenter un haut-parleur **R44** en tension, il est également possible d'utiliser le circuit d'alimentation de l'invention pour un amplificateur audio haute puissance en courant, c'est-à-dire pour alimenter un haut-parleur en courant.

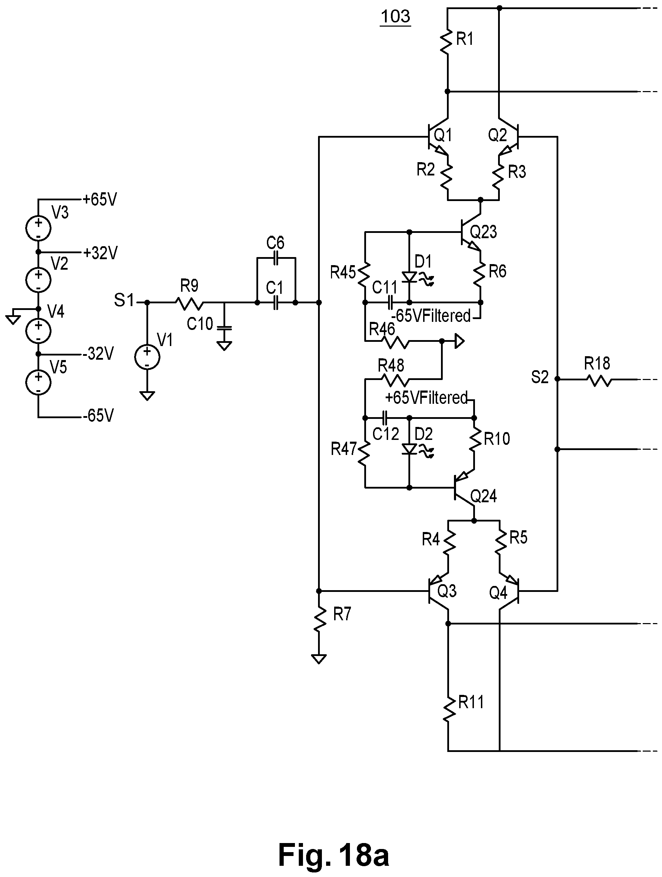

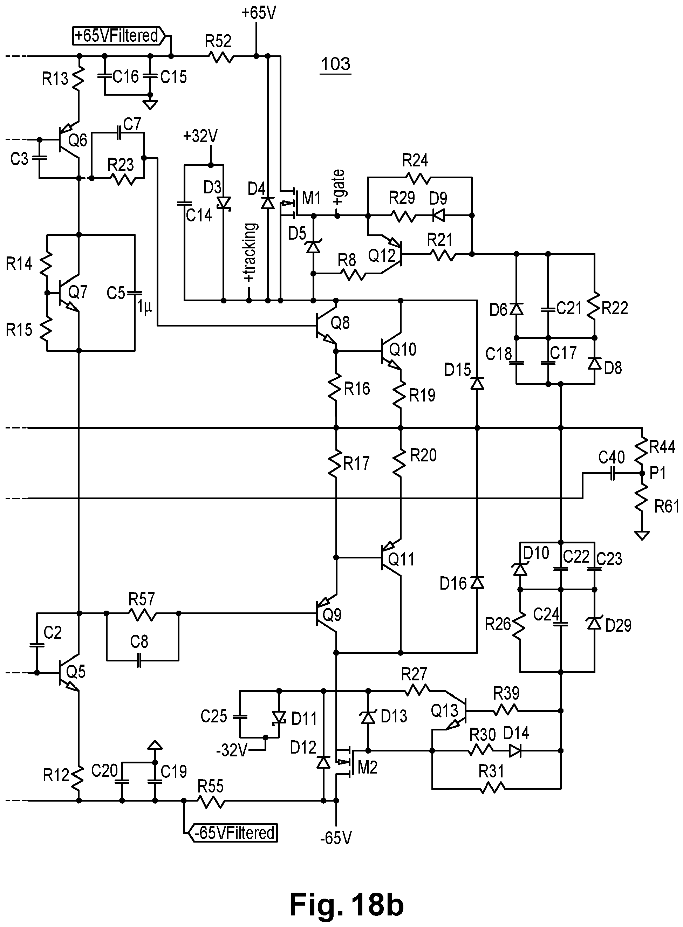

Pour ce faire, tel qu'illustré sur la figure 18a-18b une résistance de mesure de courant **R61** est insérée entre le haut-parleur **R44** et la masse. En outre, l'amplificateur en courant **103** ne présente pas de ligne de protection **403.** Les bases des transistors **Q2** et **Q4** sont reliées à un point d'interconnexion situé entre la résistance **R61** et le haut-parleur **R44** par l'intermédiaire d'un condensateur **C40.** Ce condensateur **C40** ne laisse donc passer que la composante alternative du signal.

Dans cette configuration, le haut-parleur **R44** est donc traversé par un courant alternatif dont une image est appliquée au point **S2.** Il s'ensuit que la transconductance de l'amplificateur est égale à **1/R61** pour un signal alternatif.

En variante, afin de protéger le haut-parleur **R44** et l'amplificateur lui-même, une résistance peut être ajoutée à la contre-réaction, entre le point **S2** et la sortie de l'amplificateur **3.** Dans le cas d'une composante continue aux bornes du haut-parleur **R44,** la composante continue est appliquée aux bases des transistors **Q2** et **Q4** par l'intermédiaire d'une résistance **R18.** La contre-réaction va tendre à annuler cette composante continue. En outre, la résistance **R18** permet de limiter le gain de l'amplificateur en l'absence de haut-parleur **R44,** l'empêchant également d'osciller. Lorsque le courant est alternatif, le condensateur **C40** a une impédance négligeable par rapport à la valeur de la résistance **R18.** En fonctionnement normal, c'est-à-dire, lorsqu'il n'y a pas de composante continue et lorsqu'un haut-parleur **R44** est effectivement présent en sortie de l'amplificateur, la résistance **R18** n'a quasiment aucun effet. En revanche, en l'absence de haut-parleur **R44** en sortie de l'amplificateur, on peut considérer que le point S2 est relié, d'une part, à la sortie de l'amplificateur par l'intermédiaire de la résistance **R18,** et, d'autre part, à la masse par l'intermédiaire de la résistance R61 puisque le condensateur **C40** se comporte comme un court-circuit en courant alternatif. L'amplification en tension sera donc limitée à (**R18 + R61**) / **R61** puisque la tension de sortie de l'amplificateur multipliée par **R61**/ (**R18 + R61**) est comparée à la tension d'entrée appliquée au point **S1** par les paires différentielles formées par les transistors **Q1/Q2** et **Q3/Q4.** L'amplificateur ne fournira alors pas sa tension de sortie maximale, ce qui aurait pu être dangereux. De même, en présence d'une composante continue et en présence ou en l'absence de haut-parleur R44 en sortie de l'amplificateur, le condensateur se comporte comme un circuit ouvert, la composante continue est ainsi réinjectée au point **S2** par l'intermédiaire de la résistance **R18.** Le gain en tension est ainsi limité à 1 pour les tensions continues, ce qui ne risque pas d'endommager le haut-parleur **R44.**

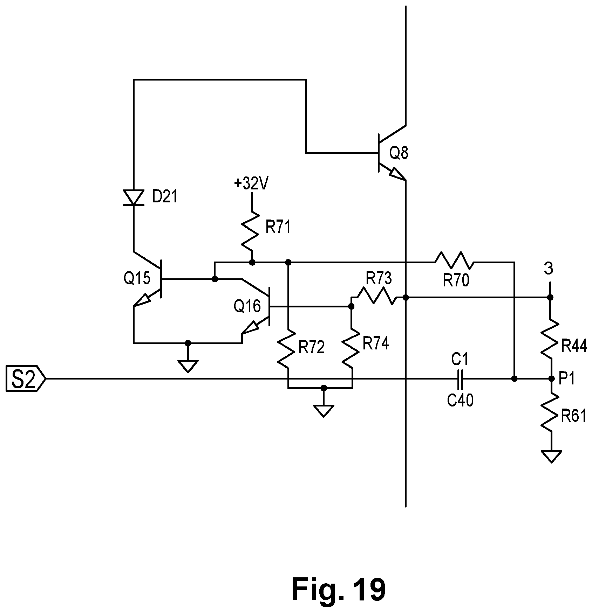

Dans une autre variante, un circuit de protection de l'amplificateur en courant peut être ajouté. Pour ce faire, tel qu'illustré sur la figure 19, le point d'interconnexion **P1** situé entre la résistance **R61** et le haut-parleur **R44** est connecté à une première borne d'une résistance **R70.** Dans ce mode de réalisation, la seconde borne de la résistance **R70** est connectée au collecteur d'un transistor **Q16.** Le collecteur du transistor **Q16** est également connecté à la base d'un deuxième transistor **Q15.** Le diviseur de tension constitué par les résistances **R71** et **R72** permet d'adapter le seuil de courant à partir duquel le circuit de protection agit. La première borne de la résistance **R71** est connectée au second bus d'alimentation **V+** d'une valeur de 32 V. La seconde borne de la résistance **R71** est connectée à la base du transistor **Q15** et au collecteur du transistor **Q16.** La première borne de la résistance **R72** est connectée à la seconde borne de la résistance **R70** et la seconde borne de la résistance **R72** est reliée à la masse. La tension de seuil de conduction du transistor **Q15** est ainsi décalée de : **V+*R72** / (**R71** + **R72**). Ceci permet d'augmenter la sensibilité, c'est-à-dire que le seuil de courant à partir duquel la protection agit est abaissé.

De préférence, le transistor **Q15** est un darlington. Ceci permet de limiter la distorsion due au circuit en prélevant un courant moindre aux bornes de la résistance de mesure **R61** tout en conservant une sensibilité suffisante grâce au réseau diviseur **R71** / **R72.** Un autre pont diviseur constitué des résistances **R73** et **R74** est inséré entre le point **3** et la masse. La première borne de la résistance **R73** est connectée au point **3.** La seconde borne de la résistance **R73** est connectée à la base du transistor **Q16** et à la première borne de la résistance **R74.** La seconde borne de cette dernière est reliée à la masse. Ainsi, on adapte le seuil de tension à partir duquel la protection en courant est neutralisée. Les émetteurs des transistors **Q16** et **Q15** sont connectés entre eux et à la masse, et le collecteur du transistor **Q15** est connecté à la base du transistor **Q8** par l'intermédiaire d'une diode **D21,** dont la cathode est reliée au collecteur du transistor **Q15.**

Ce circuit doit être dupliqué en miroir pour gérer la protection en courant lors de l'alternance négative, les transistors de type NPN sont alors remplacés par des transistors de type PNP.

Ce circuit permet de limiter les risques de casse en puissance de l'amplificateur en courant, notamment lorsque celui-ci est surchargé ou lorsque sa sortie est court-circuitée. En effet, dans ces cas de figure, le produit du courant de sortie par la tension des bus d'alimentation sera intégralement dissipé par les transistors et ceux-ci pourraient être endommagés.

Avec le circuit de la figure 19, si le courant dans la résistance de mesure de courant **R61** est suffisant pour rendre le transistor **Q15** passant, celui-ci peut, par l'intermédiaire de la diode **D21,** évacuer le signal provenant de la base du transistor **Q8** vers la masse, de sorte à le bloquer. En revanche, si la tension aux bornes du haut-parleur **R44** est suffisante pour rendre le transistor **Q16** passant, le signal provenant de la base du transistor **Q15** sera dérivé à la masse et c'est ce dernier qui sera bloqué. Le circuit de protection est ainsi neutralisé en présence d'une tension suffisante en sortie de l'amplificateur.

Pour conclure, l'invention permet d'obtenir un amplificateur audio haute puissance permettant de limiter les déformations identifiées sur les signaux et donc d'améliorer le rendement et de réduire la saturation de l'amplificateur.

## Revendications

1. Amplificateur audio haute puissance (102) destiné à commander au moins un haut-parleur (R44), ledit amplificateur comportant :
- un étage de pré-amplification (201, 301) recevant un signal d'entrée (S1) ;
- un étage d'amplification de puissance (202-203, 302) connecté à l'étage de pré-amplification (201, 301) et fournissant un signal de sortie (3) destiné à alimenter ledit au moins un haut-parleur (R44) ; les étages de pré-amplification (201, 301) et d'amplification de puissance (202-203, 302) comportant une partie supérieure et une partie inférieure montées en miroir ;
- une contre-réaction fournissant à l'étage de pré-amplification (201, 301) une image du signal de sortie (3),
- un circuit d'alimentation supérieur (151-155, 155a), connecté à la partie supérieure de l'étage d'amplification de puissance (202-203, 302), et permettant de l'alimenter par un premier ou un second bus d'alimentation (V++, V+) ;
- un circuit d'alimentation inférieur (155b) connecté à la partie inférieure de l'étage d'amplification de puissance (202-203, 302) et permettant de l'alimenter par un premier ou un second bus d'alimentation ;
- chaque circuit d'alimentation (151-155, 155a, 155b) comportant un transistor MOSFET (M1, M2) et des moyens de supervision, le transistor MOSFET (M1, M2) étant commandé par les moyens de supervision de sorte à réaliser la commutation entre l'un ou l'autre des deux bus d'alimentation (V++, V+), **caractérisé en ce que** le transistor MOSFET (M1, M2) étant relié au second bus d'alimentation (V+) par l'intermédiaire d'une quatrième diode (D3, D11) dont une première borne est reliée à la source du transistor MOSFET (M1, M2), et le drain du transistor MOSFET (M1, M2) étant relié au premier bus d'alimentation (V++), dans lequel chaque circuit d'alimentation (151-155, 155a, 155b) comporte en outre :
- un sous-circuit d'aide à la charge (131-133) dudit transistor MOSFET (M1, M2) comportant au moins une première résistance (R24, R31), une première borne de la première résistance (R24, R31) étant connectée à la grille du transistor MOSFET (M1, M2) et une seconde borne de la première résistance (R24, R31) étant connectée à un point d'interconnexion (A1) ;
- un sous-circuit d'aide à la décharge (141) dudit transistor MOSFET (M1, M2) comportant au moins une deuxième et une troisième résistance (R8, R27, R21, R39) et un transistor bipolaire (Q12, Q13) ; la base du transistor bipolaire (Q12, Q13) étant connectée sur une première borne de la troisième résistance (R21, R39), son émetteur étant connecté à la grille du transistor MOSFET (M1, M2) et son collecteur étant connecté à la source du transistor MOSFET (M1, M2) par l'intermédiaire de la deuxième résistance (R8), la seconde borne de la troisième résistance (R21, R39) étant connectée sur le point d'interconnexion (A1, A2) ; et
- un sous-circuit de décalage de tension (161-163) comportant une première diode (D8, D10) montée en parallèle avec un premier condensateur (C18, C23) ; une première borne de la première diode (D8, D10) et une première borne du premier condensateur (C18, C23) étant connectées sur un premier nœud d'interconnexion (N1, N4), lui-même connecté audit point d'interconnexion (A1, A2) dudit sous-circuit d'aide à la décharge (141) ; une seconde borne de la première diode (D8, D10) et une seconde borne du premier condensateur (C18, C23) étant connectées sur un second nœud d'interconnexion (N2, N3), lui-même connecté audit signal de sortie (3).

2. Amplificateur selon la revendication 1, ***caractérisé en ce que*** le sous-circuit de décalage de tension (161-163) comporte en outre au moins une quatrième résistance (R22, R26) et une deuxième diode (D6, D29) montés en parallèle, une première borne de la deuxième diode (D6, D29) et une borne de la quatrième résistance (R22, R26) étant reliées au point d'interconnexion (A1, A2), une seconde borne de la quatrième résistance (R22, R26) et une seconde borne de la deuxième diode (D6, D29) étant reliées à un troisième nœud d'interconnexion (N10).

3. Amplificateur selon la revendication 1 ou 2, ***caractérisé en ce que*** le sous-circuit d'aide à la charge (131-133) comporte en outre une cinquième résistance (R29, R30) montée en série avec une troisième diode (D9, D14), la cinquième résistance (R29, R30) et la troisième diode (D9, D14) étant montées en parallèle de la branche du sous-circuit d'aide à la charge (131-133) incluant la première résistance (R24, R31).

4. Amplificateur selon l'une des revendications 1 à 3, ***caractérisé en ce que*** le sous-circuit de décalage de tension (161-163) comporte en outre un deuxième condensateur (C17, C22) et un troisième condensateur (C21, C24), le deuxième condensateur (C17, C22) étant monté en parallèle du premier condensateur (C18, C23) et de la première diode (D8, D10) et le troisième condensateur (C21, C24) étant monté en parallèle de la deuxième diode (D6, D29) et de la cinquième résistance (R22, R26).

5. Amplificateur selon l'une des revendications 1 à 4, ***caractérisé en ce que*** chaque circuit d'alimentation (151-155, 155a, 155b) comporte une première diode de protection (D5, D13) dont une première borne est connectée à la source du transistor MOSFET (M1, M2) et dont une seconde borne est connectée à la grille du transistor MOSFET (M1, M2).

6. Amplificateur selon l'une des revendications 1 à 5, ***caractérisé en ce que*** chaque circuit d'alimentation (151-155, 155a, 155b) comporte en outre une seconde diode de protection (D4, D12) connectée entre la source et le drain du transistor MOSFET (M1, M2).

7. Amplificateur selon l'une des revendications 1 à 6, ***caractérisé en ce que*** chaque circuit d'alimentation (151-155, 155a, 155b) comporte en outre un quatrième condensateur (C14, C25) monté en parallèle de la quatrième diode (D3, D11).

8. Amplificateur selon l'une des revendications 1 à 7, ***caractérisé en ce que*** l'étage de pré-amplification (201, 301) est connecté au premier bus d'alimentation (V++) de chaque circuit d'alimentation (151-155, 155a, 155b) par le biais d'un circuit d'amortissement des variations de puissance (304, 305) dudit premier bus d'alimentation (V++), ledit circuit d'amortissement des variations de puissance (304, 305) comportant au moins un condensateur (C15, C19) et au moins une résistance (R52, R55) montés en filtre passe-bas.

9. Amplificateur selon la revendication 8, ***caractérisé en ce que*** ledit circuit d'amortissement des variations de puissance (304, 305) comporte en outre un condensateur supplémentaire monté en parallèle de l'au moins un condensateur (C16, C20).

10. Amplificateur selon l'une des revendications 1 à 9, ***caractérisé en ce que*** la contre-réaction appliquée à l'étage de pré-amplification fournit un signal proportionnel au courant traversant le haut-parleur.

## Patentansprüche

1. Hochleistungsfähiger Audioverstärker (102) zur Steuerung mindestens eines Lautsprechers (R44), wobei der Verstärker Folgendes umfasst:
- eine Vorverstärkerstufe (201, 301), die ein Eingangssignal (S1) empfängt;
- eine Leistungsverstärkerstufe (202-203, 302), die mit der Vorverstärkerstufe (201, 301) verbunden ist und ein Ausgangssignal (3) zur Versorgung des mindestens einen Lautsprechers (R44) abgibt; wobei die Vorverstärkerstufen (201, 301) und die Leistungsverstärkerstufe (202-203, 302) einen oberen und einen unteren Teil aufweisen, die spiegelbildlich angeordnet sind;
- eine Rückkopplung, die der Vorverstärkerstufe (201, 301) ein Abbild des Ausgangssignals (3) liefert;
- eine obere Versorgungsschaltung (151-155, 155a), die mit dem oberen Teil der Leistungsverstärkerstufe (202-203, 302) verbunden ist und diesen über einen ersten oder zweiten Versorgungsbus (V++, V+) versorgt;
- eine untere Versorgungsschaltung (155b), die mit dem unteren Teil der Leistungsverstärkerstufe (202-203, 302) verbunden ist und diesen über einen ersten oder zweiten Versorgungsbus versorgt;
- jede Versorgungsschaltung (151-155, 155a, 155b) umfasst einen MOSFET-Transistor (M1, M2) und Überwachungsmittel, wobei der MOSFET-Transistor (M1, M2) von den Überwachungsmitteln so gesteuert wird, dass er zwischen dem einen oder dem anderen der beiden Versorgungsbusse (V++, V+) umschaltet,
- ***dadurch gekennzeichnet,* dass** der MOSFET-Transistor (M1, M2) über eine vierte Diode (D3, D11) mit dem zweiten Versorgungsbus (V+) verbunden ist, deren erster Anschluss mit der Source des MOSFET-Transistors (M1, M2) verbunden ist, und der Drain des MOSFET-Transistors (M1, M2) mit dem ersten Versorgungsbus (V++) verbunden ist, wobei jede Versorgungsschaltung (151-155, 155a, 155b) ferner Folgendes umfasst:
- eine Teilschaltung zur Lastunterstützung (131-133) des MOSFET-Transistors (M1, M2) mit mindestens einem ersten Widerstand (R24, R31), wobei ein erster Anschluss des ersten Widerstands (R24, R31) mit dem Gate des MOSFET-Transistors (M1, M2) verbunden ist und ein zweiter Anschluss des ersten Widerstands (R24, R31) mit einem Zwischenschaltungspunkt (A1) verbunden ist;
- eine Teilschaltung zur Entladungsunterstützung (141) des MOSFET-Transistors (M1, M2), die mindestens einen zweiten und einen dritten Widerstand (R8, R27, R21, R39) und einen Bipolartransistor (Q12, Q13) umfasst; wobei die Basis des Bipolartransistors (Q12, Q13) mit einem ersten Anschluss des dritten Widerstands (R21, R39) verbunden ist, sein Emitter mit dem Gate des MOSFET-Transistors (M1, M2) verbunden ist, und sein Kollektor über den zweiten Widerstand (R8) mit der Source des MOSFET-Transistors (M1, M2) verbunden ist und der zweite Anschluss des dritten Widerstands (R21, R39) über den Zwischenschaltungspunkt (A1, A2) verbunden ist; und
- eine Teilschaltung zur Spannungsschiebung (161-163) mit einer ersten Diode (D8, D10), die parallel zu einem ersten Kondensator (C18, C23) geschaltet ist; wobei ein erster Anschluss der ersten Diode (D8, D10) und ein erster Anschluss des ersten Kondensators (C8, C23) mit einem ersten Verbindungsknoten (N1, N4) verbunden sind, der seinerseits mit dem Zwischenschaltungspunkt (A1, A2) der Teilschaltung zur Entladungsunterstützung (141) verbunden ist; wobei ein zweiter Anschluss der ersten Diode (D8, D10) und ein zweiter Anschluss des ersten Kondensators (C18, C23) an einen zweiten Verbindungsknoten (N2, N3) angeschlossen sind, der seinerseits mit dem Ausgangssignal (3) verbunden ist.

2. Verstärker nach Anspruch 1, ***dadurch gekennzeichnet,* dass** die Teilschaltung zur Spannungsverschiebung (161-163) ferner mindestens einen vierten Widerstand (R22, R26) und eine zweite Diode (D6, D29) aufweist, die parallel geschaltet sind, wobei ein erster Anschluss der zweiten Diode (D6, D29) und ein Anschluss des vierten Widerstands (R22, R26) mit dem Zwischenschaltungspunkt (A1, A2) verbunden sind und ein zweiter Anschluss des vierten Widerstands (R22, R26) und ein zweiter Anschluss der zweiten Diode (D6, D29) mit einem dritten Verbindungsknoten (N10) verbunden sind.

3. Verstärker nach Anspruch 1 oder 2, ***dadurch gekennzeichnet,* dass** die Teilschaltung zur Lastunterstützung (131-133) außerdem einen fünften Widerstand (R29, R30) umfasst, der mit einer dritten Diode (D9, D14) in Reihe geschaltet ist, wobei der fünfte Widerstand (R29, R30) und die dritte Diode (D9, D14) parallel zum Zweig der Teilschaltung zur Lastunterstützung (131-133) geschaltet sind, der den ersten Widerstand (R24, R31) umfasst.

4. Verstärker nach einem der Ansprüche 1 bis 3, ***dadurch gekennzeichnet,* dass** die Teilschaltung zur Spannungsverschiebung (161-163) ferner einen zweiten Kondensator (C17, C22) und einen dritten Kondensator (C21, C24) umfasst, wobei der zweite Kondensator (C17, C22) parallel zum ersten Kondensator (C18, C23) und zur ersten Diode (D8, D19) geschaltet ist und der dritte Kondensator (C21, C24) parallel zur zweiten Diode (D6, D29) und zum fünften Widerstand (R22, R26) geschaltet ist.

5. Verstärker nach einem der Ansprüche 1 bis 4, ***dadurch gekennzeichnet,* dass** jede Versorgungsschaltung (151-155, 155a, 155b) eine erste Schutzdiode (D5, D13) aufweist, deren erster Anschluss mit der Source des MOSFET-Transistors (M1, M2) verbunden ist und deren zweiter Anschluss mit dem Gate des MOSFET-Transistors (M1, M2) verbunden ist.

6. Verstärker nach einem der Ansprüche 1 bis 5, ***dadurch gekennzeichnet,* dass** jede Versorgungsschaltung (151-155, 155a, 155b) außerdem eine zweite Schutzdiode (D4, D12) aufweist, die zwischen der Source und dem Drain des MOSFET-Transistors (M1, M2) geschaltet ist.

7. Verstärker nach einem der Ansprüche 1 bis 6, ***dadurch gekennzeichnet,* dass** jede Versorgungsschaltung (151-155, 155a, 155b) außerdem einen vierten Kondensator (C14, C25) enthält, der parallel zur vierten Diode (D3, D11) geschaltet ist.

8. Verstärker nach einem der Ansprüche 1 bis 7, ***dadurch gekennzeichnet,* dass** die Vorverstärkerstufe (201, 301) über eine Schaltung zur Dämpfung von Leistungsschwankungen (304, 305) des ersten Versorgungsbusses (V++) mit dem ersten Versorgungsbus (V++) jeder Versorgungsschaltung (151-155, 155a, 155b) verbunden ist, wobei die Schaltung zur Dämpfung von Leistungsschwankungen (304, 305) mindestens einen Kondensator (C15, C19) und mindestens einen Widerstand (R52, R55) umfasst, die als Tiefpassfilter geschaltet sind.

9. Verstärker nach Anspruch 8, ***dadurch gekennzeichnet,* dass** die Schaltung zur Dämpfung von Leistungsschwankungen (304, 305) außerdem einen zusätzlichen Kondensator enthält, der parallel zu dem mindestens einen Kondensator (C16, C20) geschaltet ist.

10. Verstärker nach einem der Ansprüche 1 bis 9, ***dadurch gekennzeichnet,* dass** die Rückkopplung der Vorverstärkerstufe ein Signal abgibt, das proportional zum Strom ist, der durch den Lautsprecher fließt.

## Claims

1. A high-power audio amplifier (102) intended to control at least one loudspeaker (R44), said amplifier comprising:
- a pre-amplification stage (201, 301) that receives an input signal (S1);
- a power amplification stage (202-203, 302), which is connected to the pre-amplification stage (201, 301) and supplies an output signal (3) intended to power said at least one loudspeaker (R44); the pre-amplification (201, 301) and power amplification stages (202-203, 302) comprising an upper part and a lower part mounted mirroring each other;
- a feedback supplying the pre-amplification stage (201, 301) with an image of the output signal (3),
- an upper power supply circuit (151-155, 155a), which is connected to the upper part of the power amplification stage (202-203, 302), and enabling it to be powered by a first or a second power bus (V++, V+);
- a lower power supply circuit (155b),which is connected to the lower part of the power amplification stage (202-203, 302), and enabling it to be powered by a first or a second power bus;
- each power supply circuit (151-155, 155a, 155b) comprising a MOSFET transistor (M1, M2) and monitoring means, the MOSFET transistor (M1, M2) being controlled by the supervision means so as to carry out switching between one or the other of the two power buses (V++, V+), the MOSFET transistor (M1, M2) being connected to the second power bus (V+) via a fourth diode (D3, D11) of which a first terminal is connected to the source of the MOSFET transistor (M1, M2), and the drain of the MOSFET transistor (M1, M2) being connected to the first power bus (V++), ***characterized in that*** each power supply circuit (151-155, 155a, 155b) further comprises:
- a sub-circuit for assisting with charging (131-133) said MOSFET transistor (M1, M2), comprising at least a first resistor (R24, R31), a first terminal of the first resistor (R24, R31) being connected to the gate of the MOSFET transistor (M1, M2) and a second terminal of the first resistor (R24, R31) being connected to an interconnection point (A1);
- a sub-circuit for assisting with discharging (141) said MOSFET transistor (M1, M2) comprising at least a second and a third resistor (R8, R27, R21, R39) and a bipolar transistor (Q12, Q13); the base of the bipolar transistor (Q12, Q13) being connected to a first terminal of the third resistor (R21, R39), its emitter being connected to the gate of the MOSFET transistor (M1, M2) and its collector being connected to the source of the MOSFET transistor (M1, M2) via the second resistor (R8), the second terminal of the third resistor (R21, R39) being connected to the interconnection point (A1, A2); and
- a voltage-shifting sub-circuit (161-163) comprising a first diode (D8, D10) mounted in parallel with a first capacitor (C18, C23); a first terminal of the first diode (D8, D10) and a first terminal of the first capacitor (C18, C23) being connected to a first interconnection node (N1, N4), which is itself connected to said interconnection point (A1, A2) of said sub-circuit for assisting with discharging (141); a second terminal of the first diode (D8, D10) and a second terminal of the first capacitor (C18, C23) being connected to a second interconnection node (N2, N3), which is itself connected to said output signal (3).

2. The amplifier according to claim 1, ***characterized in that*** the voltage-shifting sub-circuit (161-163) further comprises at least a fourth resistor (R22, R26) and a second diode (D6, D29), which are mounted in parallel, a first terminal of the second diode (D6, D29) and a terminal of the fourth resistor (R22, R26) being connected to the interconnection point (A1, A2), a second terminal of the fourth resistor (R22, R26) and a second terminal of the second diode (D6, D29) being connected to a third interconnection node (N10).

3. The amplifier according to claim 1 or 2, ***characterized in that*** the sub-circuit for assisting with charging (131-133) further comprises a fifth resistor (R29, R30), which is mounted in series with a third diode (D9, D14), the fifth resistor (R29, R30) and the third diode (D9, D14) being mounted in parallel with the branch of the sub-circuit for assisting with charging (131-133) including the first resistor (R24, R31).

4. The amplifier according to any one of claims 1 to 3, ***characterized in that*** the voltage-shifting sub-circuit (161-163) further comprises a second capacitor (C17, C22) and a third capacitor (C21, C24), the second capacitor (C17, C22) being mounted in parallel with the first capacitor (C18, C23) and the first diode (D8, D10) and the third capacitor (C21, C24) being mounted in parallel with the second diode (D6 , D29) and the fifth resistor (R22, R26).

5. The amplifier according to any one of claims 1 to 4, ***characterized in that*** each power supply circuit (151-155, 155a, 155b) comprises a first protection diode (D5, D13) of which a first terminal is connected to the source of the MOSFET transistor (M1, M2) and of which a second terminal of which is connected to the gate of the MOSFET transistor (M1, M2).

6. The amplifier according to any one of claims 1 to 5, ***characterized in that*** each power supply circuit (151-155, 155a, 155b) further comprises a second protection diode (D4, D12) connected between the source and the drain of the MOSFET transistor (M1, M2).

7. The amplifier according to any one of claims 1 to 6, ***characterized in that*** each power supply circuit (151-155, 155a, 155b) further comprises a fourth capacitor (C14, C25) mounted in parallel with the fourth diode (D3, D11).

8. The amplifier according to any one of claims 1 to 7, ***characterized in that*** the pre-amplification stage (201, 301) is connected to the first power bus (V++) of each power circuit (151-155 , 155a, 155b) by means of a power variation damping circuit (304, 305) of said first power bus (V++), said power variation damping circuit (304, 305) comprising at at least one capacitor (C15, C19) and at least one resistor (R52, R55) which are mounted as low-pass filter.

9. The amplifier according to claim 8, ***characterized in that*** said power variation damping circuit (304, 305) further comprises an additional capacitor mounted in parallel with the at least one capacitor (C16, C20).

10. The amplifier according to any one of claims 1 to 9, ***characterized in that*** the feedback applied to the pre-amplification stage supplies a signal proportional to the current passing through the loudspeaker.
